# EUROPEAN PATENT APPLICATION

(11) **EP 4 583 147 A1**
(43) Date of publication of application: **09.07.2025**
(21) Application number: 23889000.8
(22) Date of filing: 27.10.2023
(51) Int. Cl.: H01J 37/32, H05H 1/46, H01Q 1/26

(54) **ANTENNA STRUCTURE**

(30) Priority: 09.11.2022 KR 20220148704; 20.09.2023 KR 20230125642
(71) Applicant: EN2CORE TECHNOLOGY INC., Daejeon 34127 (KR)
(72) Inventor: LEE, Yun-Seong, Sejong 30130 (KR); KIM, Du-Eil, Seoul 01387 (KR); PARK, Jun-hyeok, Daejeon 34307 (KR); CHAE, Dae-Seok, Daejeon 34904 (KR); CHO, Keon Hee, Daejeon 34167 (KR)
(74) Representative: Walaski, Jan Filip
(86) International application number: PCT/KR2023/016857
(87) International publication number: WO 2024/101738

(57) **Abstract**

According to an embodiment of the present disclosure, An antenna structure disposed around a side perimeter of a discharging tube providing a space in which a plasma is generated may be provided. The antenna structure comprises n unit antennas, each of n unit antennas comprises: a first arc section, having a first radius of curvature, a second arc section, having a second radius of curvature, and an arc connecting section connecting the first arc section and the second arc section, and m-th unit antenna and (m+1)-th unit antenna adjacent to each other are disposed so that an angle formed by an arc connecting section of the m-th unit antenna and an arc connecting section of the (m+1)-th unit antenna in basis of the center of the discharging tube is 360/n degree.

## Description

### CROSS REFERENCE TO RELATED APPLICATION

The present application claims priority to Korean Patent Application No. 10-2022-0148704, filed on November 09, 2022, and Korean Patent Application No. 10-2023-0125642, filed on September 20, 2023, the entire contents of which are incorporated herein for all purposes by this reference.

### BACKGROUND

### Technical Field

The present disclosure relates to an antenna structure. More specifically, it relates to an antenna structure designed to improve the durability and efficiency of a plasma induction system.

### Description of the Related Art

Plasma processing technologies that utilize plasma are used not only in semiconductors, displays, and medical equipment technologies, but also in a wide range of industries such as environmental technologies including air, water, and soil purification, and energy technologies including solar cells and hydrogen energy. Among plasma processing technologies, research on an inductively coupled discharge that forms high-density plasma with low power is actively being conducted.

An inductively coupled discharge is generally generated by applying electric power to an antenna structure, and the shape or structure of the antenna structure should be treated as a very important technological variable when considering the stability, durability, and efficiency of a system that induces plasma.

Meanwhile, the scale of a system that induces plasma or the density of plasma may vary depending on the demands of industrial fields, and as the scale of the system increases or the density of plasma increases, the electric power or frequency applied to the antenna structure increases, thereby causing some problems in the durability of the antenna structure and the stability of the system.

The present disclosure proposes an antenna structure designed to ensure the stability and durability of a system while complying with the required system scale or plasma density.

### SUMMARY

One objective the present disclosure achieves is to provide an antenna structure with a strong induction coupling in the process of generating an inductively coupled plasma.

One objective the present disclosure achieves is to provide an antenna structure to increase the stability and durability of a system in a plasma induction system that induces plasma by receiving high-frequency power of several MHz.

One objective the present disclosure achieves is to provide an antenna structure to apply a relatively weak voltage to an antenna adjacent to an outer wall of a discharging tube in the process of inducing plasma to the discharging tube (or dielectric tube).

One objective the present disclosure achieves is to provide an antenna structure that is easy to design and manufacture.

One objective the present disclosure achieves is to minimize the use of auxiliary gas in an inductively coupled plasma (ICP) induction.

The objects of the present disclosure are not limited to the aforementioned objects, and other objects which are not described herein should be clearly understood by those skilled in the art, to which the present disclosure belongs, from the following detailed description and the accompanying drawings.

According to an embodiment, an antenna structure disposed around a side perimeter of a discharging tube providing a space in which a plasma is generated is provided. The antenna structure comprises: n unit antennas including a first unit antenna to n-th unit antenna, where n is natural number greater than or equal to 2, wherein each of n unit antennas comprises: a first arc section, having a first radius of curvature, including a first end and a second end;a second arc section, having a second radius of curvature, including a third end and a fourth end; and an arc connecting section, the second end of the first arc section and the third end of the second arc section. wherein m-th unit antenna and (m+1)-th unit antenna are disposed so that an angle formed by a first virtual line and a second virtual line is 360/n degree, wherein the first virtual line is drawn between a center of the discharging tube and an arc connecting section of the m-th unit antenna, wherein the second virtual line is drawn between the center of the discharging tube and an arc connecting section of the (m+1)-th unit antenna, wherein the m-th unit antenna and the (m+1)-th unit antenna are adjacent and m is natural number smaller than n, and wherein the first radius of curvature is different from the second radius of curvature.

Technical solutions of the present disclosure may not be limited to the above, and other technical solutions which are not described herein should be clearly understood by those skilled in the art, to which the present disclosure belongs, from the present specification and the accompanying drawings.

According to an exemplary embodiment, the stability and durability of a plasma induction system may be improved.

According to an exemplary embodiment, plasma may be stably induced and maintained because ion losses within a discharging tube in a plasma induction system may be reduced.

According to an exemplary embodiment, damage to a discharging tube in a plasma induction system may be prevented.

According to an exemplary embodiment, an antenna structure having the effects described above may be easily manufactured, and the manufacturing cost may be reduced.

According to an exemplary embodiment, the cost may be reduced depending on the amount of auxiliary gas used in plasma discharge.

Effects of the present disclosure may not be limited to the above, and other effects which are not described herein should be clearly understood by those skilled in the art, to which the present disclosure belongs, from the present specification and the accompanying drawings.

### BRIEF DESCRIPTION OF THE DRAWINGS

FIG. 1 is a block diagram of a plasma induction system according to an exemplary embodiment.
FIG. 2 is a view showing a radio frequency (RF) generator according to an exemplary embodiment.
Fig. 3 is a view showing an antenna structure and a discharging tube according to an exemplary embodiment.
FIGS. 4 and 5 are views showing conventional antenna structures, respectively.
FIG. 6 is a view showing a structure and a shape of one layer of an antenna structure according to a first exemplary embodiment.
FIG. 7 is a view showing a connection relationship among antenna segments in an antenna structure according to the first exemplary embodiment.
FIG. 8 is a view showing a voltage depending on a position in an antenna structure according to an exemplary embodiment.
FIG. 9 is a view showing layer antennas of an antenna structure according to an exemplary embodiment.
FIG. 10 is a view showing layer antennas of an antenna structure according to another exemplary embodiment.
FIG. 11 is a view showing an antenna structure according to a second exemplary embodiment.
FIG. 12 is a view showing an antenna structure according to a third exemplary embodiment.
FIG. 13 is a view showing an antenna structure according to a fourth exemplary embodiment.
FIG. 14 (a) is a view showing a unit antenna according to an exemplary embodiment.
FIG. 14 (b) is a plan view of a unit antenna according to an exemplary embodiment.
FIG. 15 (a) is a view showing an antenna structure composed of unit antennas according to an exemplary embodiment.
FIG. 15 (b) is a plan view of an antenna structure according to an exemplary embodiment.
FIG. 16 (a) is a plan view of a unit antenna according to another exemplary embodiment.
FIG. 16 (b) is a plan view of an antenna structure composed of unit antennas according to another exemplary embodiment.
FIG. 17 is a plan view of a unit antenna according to another exemplary embodiment.
FIG. 18 is a plan view of an antenna structure composed of unit antennas according to another exemplary embodiment.
FIGS. 19 are views showing a capacitor module according to an exemplary embodiment.
FIG. 20 is a view showing capacitor module interposed among unit antennas according to an exemplary embodiment.
FIG. 21 is a diagram of a gas reforming system according to an exemplary embodiment.
FIG. 22 is a diagram of a pre-processing portion according to an exemplary embodiment.
FIG. 23 is a view showing a plasma induction system for gas reforming according to an exemplary embodiment.
FIG. 24 is a flowchart showing a plasma reforming method according to an exemplary embodiment.
FIGS. 25is a view showing main antenna structures having differently adjusted parasitic capacitances according to exemplary embodiments.
FIGS. 26 is a view showing lower swirl generator according to exemplary embodiments.

According to an embodiment, an antenna structure disposed around a side perimeter of a discharging tube providing a space in which a plasma is generated is provided. The antenna structure comprises: n unit antennas including a first unit antenna to n-th unit antenna, where n is natural number greater than or equal to 2, wherein each of n unit antennas comprises: a first arc section, having a first radius of curvature, including a first end and a second end;a second arc section, having a second radius of curvature, including a third end and a fourth end; and an arc connecting section, the second end of the first arc section and the third end of the second arc section. wherein m-th unit antenna and (m+1)-th unit antenna are disposed so that an angle formed by a first virtual line and a second virtual line is 360/n degree, wherein the first virtual line is drawn between a center of the discharging tube and an arc connecting section of the m-th unit antenna, wherein the second virtual line is drawn between the center of the discharging tube and an arc connecting section of the (m+1)-th unit antenna, wherein the m-th unit antenna and the (m+1)-th unit antenna are adjacent and m is natural number smaller than n, and wherein the first radius of curvature is different from the second radius of curvature.

The first radius of curvature corresponds to the side perimeter of the discharging tube, and the second radius of curvature has larger value than the first radius of curvature.

The first arc section has a first central angle, and the first central angle is equal to or less than 360/n degree.

The second arc section has a second central angle, and the second central angle is smaller than the first central angle.
n is natural number greater than or equal to 3, and m is natural number less then (n-1), and a fourth end of a second arc section of the m-th unit antenna and a first end of a first arc section of the (m+2)-th unit antenna are electrically connected when the (m+2)-th unit antenna and the (m+1)-th unit antenna are adjacent.

An inter-turn capacitor is electrically interposed between the fourth end of the second arc section of the m-th unit antenna and the first end of the first arc section of the (m+2)-th unit antenna.

The n unit antennas are disposed at a first plane to form a first layer antenna.

The first radius of curvature is smaller than the second radius of curvature, first arc sections of the first to n-th unit antennas consist of an inner turn of the first layer antenna to surround the discharging tube, and second arc sections of the first to n-th unit antennas consist of an outer turn of the first layer antenna to surround the inner turn.

The n antennas are disposed clockwise or counterclockwise at the first plane, and a second arc section of the m-th unit antenna is disposed to surround at least part of a first arc section of the (m+1)-th unit antenna.

The antenna structure further comprising: a second layer antenna consisting of p unit antennas different from the n unit antennas, p is natural number greater than or equal to 2, the second layer antenna is disposed at a second plane spaced a predetermined distance from the first plane, one of the n unit antennas and one of the p unit antennas are electrically connected through inter-layer capacitor.

n is 3, a fourth end of a second arc section of the first unit antenna is connected to a first end of a first arc section of the third unit antenna through a first inter-turn capacitor, and a fourth end of a second arc section of the third unit antenna is connected to a first end of a first arc section of the second unit antenna through a second inter-turn capacitor.

According to an embodiment, a method of reforming gas using a plasma induction system is provided. The plasma induction system comprises: a discharging tube, an ignition antenna structure surrounding the discharging tube, a main antenna structure surrounding the discharging tube and disposed to be spaced apart from the ignition antenna structure, a first RF generator configured to apply power to the ignition antenna structure, a second RF generator configured to apply power to the main antenna structure, an auxiliary gas inflow tube for flowing an auxiliary gas into the discharging tube, an exhaust port for exhausting gas inside the discharge tube and an outlet for exhausting the reformed gas inside the discharge tube. The method comprises: injecting the auxiliary gas into the discharge tube; applying power to the ignition antenna structure such that plasma is induced inside the discharging tube; applying power to the main antenna structure such that ignited plasma is maintained when a first preconfigured condition is satisfied; injecting the gas to be reformed to the discharging tube; stopping injection of the auxiliary gas; Exhausting gas in the discharge tube until a second preset condition is satisfied; and exhausting a synthesis gas in which the gas to be reformed has been reformed by plasma.

The above-described objects, characteristics, and advantages of the present disclosure will be more apparent by the following detailed description with reference to the accompanying drawings. Since the present disclosure may be variously modified and have various embodiments, specific embodiments will be shown in the accompanying drawings and described in detail in a detailed description.

In the drawings, the thicknesses of layers and regions are exaggerated for clarity. In addition, it should be understood that when an element or layer is referred to as being on another element or layer, it may be disposed directly on the other element or layer or may be disposed on the other element with an intervening layer or element therebetween. Throughout the specification, the same reference numerals denote the same elements in principle. In addition, in the drawings of each embodiment, the elements having the same function within the same scope are described using the same reference numerals and Redundant explanations will be omitted.

The numbers (for example, first, second, etc.) used in describing the present disclosure are only identification symbols for distinguishing one element from other elements.

In addition, the words "module" and "unit" for elements used in the following description are given or mixed and used considering only easiness in preparing a specification, and do not have a meaning or role distinguished from each other in themselves.

In the following embodiments, singular forms are intended to include plural forms unless the context clearly indicates otherwise.

In the following embodiments, terms such as "include" or "have" mean that the features or components described herein exist without excluding the possibility that one or more other features or components are added.

Components may be exaggerated or reduced in size for the convenience of description. For example, the sizes and thicknesses of the components shown the figures are selectively provided and the present disclosure is not necessarily limited thereto.

When an embodiment can be implemented in another way, specific processes may be performed in order different from the description. For example, two sequentially described processes may be substantially simultaneously performed or may be performed in the reverse order of the described order.

In the following embodiments, when films, regions, components are connected, it includes not only the case in which the films, the regions, and the components are directly connected, but the case in which the films, the regions, and the components are indirectly connected with other films, regions, and components therebetween.

For example, in the specification, when films, regions, and components are electrically connected, it includes not only the case in which the films, regions, and components are directly electrically connected, but the case in which the films, regions, and components are indirectly electrically connected with another film, region, and component therebetween.

### DETAILED DESCRIPTION OF THE DISCLOSURE

### [Organizing the terminology]

The present disclosure relates to an antenna structure. More specifically, it relates to an antenna structure designed to improve the durability and efficiency of a plasma induction system.

In the specification, plasma processing, which is a process of generating plasma and using the generated plasma and is used in a semiconductor process, a display process, a nano process, environment improvement, etc. In the specification, as plasma processing, semiconductor processes such as plasma ashing, plasma chemical vapor deposition (CVD), plasma etching, sputtering, surface modification, etc. are described as main embodiments, but the technical ideas of the present disclosure are not limited thereto.

Plasma is a phase in which a substance has been decomposed into electrons having negative charge and ions having positive charge due to high energy applied thereto, and may be induced or generated in various ways. Inductively Coupled Plasma, which is plasma generated by an induced electric field or capacitive electric field formed in a specific space by power supplied to a coil or an antenna, generally may be driven by high-frequency power such as a Radio Frequency (RF). Meanwhile, it is assumed hereafter for the convenience of description that plasma that is generated by a plasma generation system is inductively coupled plasma, but the technical ideas of the present disclosure are not limited thereto.
an antenna structure, including an antenna described above, may refer to an object that receives electric power and forms an induced electric field or a capacitive electric field for plasma generation. The antenna structure may be designed in various ways according to the purpose and specifications of a plasma induction system, and the shape or structure of the antenna structure may have a significant impact on the efficiency or durability of the plasma induction system.

### [Plasma Induction System]

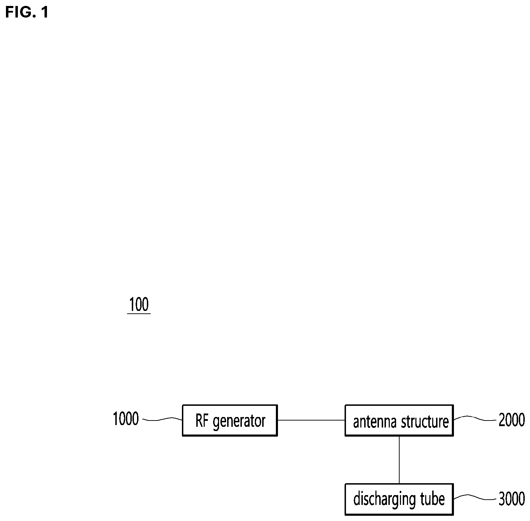

Hereinafter, a plasma induction system and its configuration will be described with reference to FIG. 1.

FIG. 1 is a diagram of a plasma induction system 100 according to an exemplary embodiment.

Referring to FIG. 1, the plasma induction system 100 may include an RF generator 1000, an antenna structure 2000, and a discharging tube 3000.

The RF generator 1000 may provide electric power to the antenna structure 2000. For example, the RF generator 1000 may apply an alternating current power having a specific driving frequency to the antenna structure 2000. Here, the alternating current power may be understood to mean an alternating current or an alternating current voltage.

The RF generator 1000 may monitor an impedance of the antenna structure 2000 and/or the electric power applied to the antenna structure 2000. Specifically, the RF generator 1000 may obtain information about the electric current or voltage flowing through the antenna structure 2000 as described later.

The RF generator 1000 may change a driving frequency of an alternating current power provided to the antenna structure 2000. The RF generator 1000 may change a driving frequency of an alternating current power provided on the basis of an impedance of the antenna structure 2000 and/or the electric power applied to the antenna structure 2000.

The antenna structure 2000 may be electrically connected to the RF generator 1000. For example, one end of the RF generator 1000 may be electrically connected to one end of the antenna structure 2000, and the other end of the RF generator 1000 may be electrically connected to the other end of the antenna structure 2000. The RF generator 1000 may be connected to the antenna structure 2000 through a separate electrical element.

In the present disclosure, one end or the other end may refer to the end portion of an object but is not limited to meaning only the end point of the object or necessarily including the end point. For example, electrically connecting one end of the antenna structure 2000 and one end of the RF generator 1000 may mean that any one end point of the antenna structure 2000 or a portion adjacent to the end point is connected to one terminal of the RF generator 1000 through a conductor such as a conducting wire. Additionally, one end or the other end may refer to an end portion of a portion of an object and this may be understood as an end point of the portion, a portion including an end point, or a portion spaced apart as much as a predetermined distance from the end point.

As described above, one end or the other end may be an expression to represent a portion of an object, and the expression itself may not limit the structure or properties of the object or the connection relationships between objects. For example, when the antenna structure 2000 is composed of multiple antenna segments and one end of one antenna segment is connected to the other end of another antenna segment, the two antenna segments may be integrally formed as one body or may be implemented as a physically separable form.

The antenna structure 2000 may form an electromagnetic field inside the discharging tube 3000 and induce plasma generation. For example, the antenna structure 2000 may form an electromagnetic field inside the discharging tube 3000 by receiving electric power from the RF generator 1000 and may then induce plasma generation. More specifically, the electromagnetic field formed inside the discharging tube 3000 by the antenna structure 2000 may periodically change its direction due to the alternating current power supplied by the RF generator 1000, and the gas supplied into the discharging tube 3000 may receive energy by the periodically changing electromagnetic field and may make a phase transition into plasma.

The antenna structure 2000 may basically have a coil-like shape surrounding the outer surface of the discharging tube (or dielectric tube).

However, even when a power source for high frequency and high power as well as for plasma formation may be supplied to the antenna structure, the antenna structure may have a specially engineered structure for its objective, the generation of the plasma and the maintenance of the plasma density.

The antenna structure 2000 may have a layered structure. For example, the same or very similar structure may be stacked in a longitudinal direction of a discharging tube (or dielectric tube).

The one layer of an antenna structure 2000 may be composed of a plurality of turns. For example, one layer of the antenna structure 2000 may be composed of two turns. Alternatively, one layer of the antenna structure 2000 may be composed of three or more turns.

The antenna structure 2000 may include at least one capacitive element. For example, a plurality of antennas constituting the antenna structure 2000 may be electrically connected to each other by capacitive elements. In addition, the antenna structure 2000 may further include a capacitive element to be connected to the RF generator 1000.

Meanwhile, a capacitive element described in the present disclosure may mean an electric condenser, a capacitor, a multilayer ceramic capacitor, an ultra-capacitor, or an equivalent circuit of a capacitive element having a function of storing electrical energy.

The discharging tube 3000 may create an environment for inducing plasma. For example, the discharging tube 3000 may define an internal space where plasma is induced.

The discharging tube 3000 may provide a space where plasma generation is induced. The discharging tube 3000 may have a pipe shape (or a hollow cylindrical shape). However, a shape of the discharging tube 3000 may be not limited to the shape of a pipe, and any shape may be sufficient when including an internal space for generating plasma.

Gas for generating plasma (e.g., NF₃, Ar, CO₂, CH₄, O₂, He, and/or H₂) may flow into the discharging tube 3000. For example, the discharging tube 3000 may be fluidly connected to at least one gas storage portion, and gas may flow from the gas storage portion into the discharging tube 3000 through a mass flow controller (MFC).

The discharging tube 3000 may be made of various materials. For example, the discharging tube 3000 may be manufactured of a non-conductive material or a material with high thermal conductivity. Specifically, the discharging tube 3000 may be manufactured of aluminum nitride (AlN), aluminum oxide (Al₂O₃) , silicon nitride (SiN), silicon nitride (Si₃N₄), silicon dioxide (SiO₂), yttrium oxide (Y₂O₃), or silicon carbide (SiC). Furthermore, the discharging tube 3000 may be manufactured of a material that does not generate particles by reacting with gas flowing into the discharging tube 3000 for plasma induction.

The discharging tube 3000 may be fluidly connected to a process chamber. Here, the process chamber defines a space where a plasma process is performed and may be understood as a chamber where a result (e.g., active species) generated in the discharging tube 3000 may flow in. For example, the discharging tube 3000 and the process chamber may be connected through a conduit, and a fluid may move from the discharging tube 3000 to the process chamber through the conduit.

The internal environment of the discharging tube 3000 may be controlled. Specifically, the temperature or pressure inside the discharging tube 3000 may be controlled to have an appropriate value or to be maintained within a certain range for plasma induction. For this, the discharging tube 3000 may include a temperature control portion such as a heating wire or a thermoelectric element. In addition, the discharging tube 3000 may include a pressure control portion for controlling internal pressure. The pressure control portion may control the pressure inside the discharging tube 3000 by monitoring the pressure inside the discharging tube 3000 and exhausting the gas inside the discharging tube 3000.

The discharging tube 3000 may be connected to an exhaust port and an outlet port.

The exhaust port may perform a function of supplying gas inside the discharging tube 3000 to an external exhaust system. In other words, when the discharging tube 3000 and the external exhaust system are fluidly connected to each other through an exhaust port, and there is gas to be exhausted from the discharging tube 3000, an exhaust pump may operate so that the gas in the discharging tube 3000 may be transferred to the exhaust system.

The outlet port may mean a passageway through which the gas reformed by plasma within the discharging tube 3000 such as active species or synthesis gas is exhausted. The outlet port is connected to a chamber where a wafer is located in a semiconductor plasma process or to a post-processing portion of a gas reforming system to be described later and serves as a passageway to provide the gas reformed in the discharging tube 3000 to a necessary location.

Hereinafter, the RF generator 1000 and the antenna structure 2000 described above will be described in more detail.

### [RF Generator]

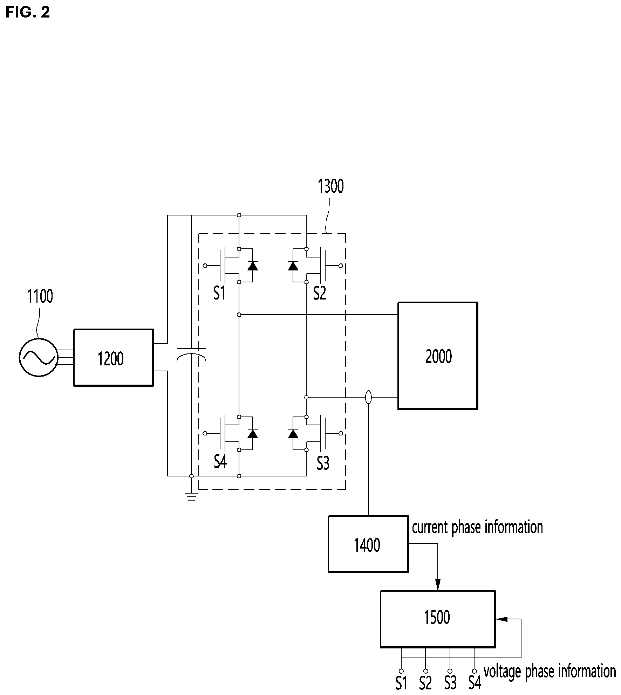

FIG. 2 is a view showing a radio frequency (RF) generator according to an embodiment of the present disclosure.

Referring to FIG. 2, the RF generator 1000 may include an AC power source 1100, a rectifier 1200, an inverter 1300, a sensor module 1400, and a controller 1500. The RF generator 10000 can convert first AC power, which is supplied from the AC power source 1100, into second AC power and supply the second AC power to a load. For example, the RF generator 1000 can convert first AC power, which is used at common home or industries, into second AC power having a frequency of hundreds of kHz to tens of MHz and a magnitude of several kW or more, and provide the second AC power to a load.

The load may include the plasma generator 2000 and plasma that is generated by the plasma generator 2000. The load may have a resonance frequency time-varying in accordance with plasma induction.

The rectifier 1200 can convert the output of the AC power source 1100 into DC. The rectifier 1200 can convert first AC power that is supplied from the AC power source 1100 into DC power and apply the DC power to both ends of the inverter 1300. Meanwhile, DC power may be construed as meaning a DC or a DC voltage in the specification.

The inverter 1300 can receive DC power from the rectifier 1200 and supply second AC power to the load. For example, the inverter 1300 can receive a switch signal from the controller 1500 and can provide second AC power to the load using the received switch signal.

The inverter 1300 may include at least one switch element that is controlled by a switch signal, and the second AC power that is supplied to the load from the inverter 1300 may have a driving frequency set based on a switch signal that the inverter 1300 is provided with from the controller 1500.

For example, the inverter 1300 may be implemented in a full bridge type. In detail, the inverter 1300 may include first to fourth switches S1, S2, S3, and S4. The first to fourth switches S1, S2, S3, and S4 can be turned on or turned off by receiving a switch signal from the controller 1500. When the first and third switches S1 and S3 are turned on and the second and fourth switches S2 and S4 are turned off, a positive voltage can be applied to the load, and when the first and third switches S1 and S3 are turned off and the second and fourth switches S2 and S4 are turned on, a negative voltage can be applied to the load. As described above, the inverter 1300 alternately applies a positive voltage and a negative voltage to the load, thereby being able to apply AC power having a specific frequency.

The method of implementing the inverter 1300 is not limited to that described above, and may mean a configuration including a circuit structure that performs a function of converting DC power into AC power.

The inverter 1300 may be controlled, for example, in a time delay type, a Pulse Width Modulation (PWM) type, or a combination thereof, depending on frequency control methods.

Meanwhile, a capacitive element may be disposed between the rectifier 1200 and the inverter 1300. For example, the RF generator 1000 includes a capacitor connected in parallel to the rectifier 1200 and the inverter 1300, and the capacitor can discharge the AC component of power applied to the inverter 1300 to a ground node GND.

A controller 1500 may generate a switch signal. Specifically, the controller 1500 may generate switch signals described above by receiving data sensed from a sensor module 1400 described later. For example, the controller 1500 may be implemented to generate a switch signal by obtaining data related to a resonance frequency such as an electric current and voltage of a load from the sensor module 1400. Specifically, the controller 1500 may generate a switch signal on the basis of obtaining the phase difference data or the delay time using the phase data of an electric current applied to the load and the phase data of a voltage applied to the load obtained from the sensor module 1400.

The controller 1500 may be implemented as a device such as a central processing unit (CPU), a microprocessor, a processor core, a multiprocessor, an application-specific integrated circuit (ASIC), or a field programmable gate array (FPGA) depending on hardware, software, or a combination thereof.

The sensor module 1400 can acquire data related to the resonance frequency of the load, or data related to power that is supplied to the load, from the controller 1500.

Though not shown in FIG. 2, the sensor module 1400 may include a current transformer, a filter, and a comparer. The sensor module 1400 can receive a current or voltage signal flowing to the load through the current transformer, convert the current or voltage signal into a current or voltage signal having a different magnitude, filter the converted current or voltage using the filter, and output phase data to the controller 1500 through the comparer.

The current transformer may be inductively coupled to a wire between the inverter 1300 and the load, and can convert and provide the voltage or current signal, which is applied to the load, to the filter. In detail, the current transformer can convert a current flowing through a conductive wire connected to the load into a voltage signal.

The filter can remove an DC component from the input current or voltage signal and then output the current or voltage signal to the comparer. To this end, the filter can perform high-band pass filtering or low-band pass filtering.

The comparer can acquire phase data. For example, the comparer can acquire phase data by comparing a voltage signal acquired from the current transformer or the filter with a preset value. The phase data may mean phase data of the current that is applied to the load.

Of course, at least one of the components included in the sensor module 1400 may be omitted and may be implemented in another way.

As described above, the RF generator 1000 may control the driving frequency of the second alternating current power provided to the load on the basis of data on the resonance frequency of a load. In other words, the RF generator 1000 may track the resonance frequency of the load that may change according to plasma generation and may output the driving frequency of the second alternating current power to correspond to the resonance frequency of the load. Accordingly, unnecessary electric power consumption may be prevented and the durability of a plasma system may be improved.

Meanwhile, though not shown in FIG. 2, the RF generator 1000 may include a memory. The memory can store various data. Various data may be temporarily or semi-permanently stored in the memory. The memory, for example, may be a Hard Disk Drive (HDD), a Solid State Drive (SSD), a flash memory, a Read-Only Memory (ROM), a Random Access Memory, etc. The memory may be implemented in a type that is disposed in or detachably attached to the RF generator 1000.

In addition, the RF generator 1000 may include an inputter for receiving input from a user. The inputter may receive a user input from a user. A user input may be made in various forms including a key input, a touch input, and a voice input. The inputter may be a comprehensive concept that may include not only traditional types such as a keypad, a keyboard, and a mouse but also a touch sensor that may detect a user's touch, and other various types of input means that may detect or receive various forms of user input.

In addition, the RF generator 1000 may include an outputor for providing information to a user. The outputormay output information on the state of a plasma induction system 100 (e.g., the sensor value measured by the sensor module 1400, the driving frequency of the RF generator 1000, the temperature of the antenna structure 2000, etc.) and may provide information to a user. The outputormay be a comprehensive concept that includes a display outputting images, a speaker outputting sound, a haptic device generating vibration, and other various types of output means.

The RF generator 1000 described above may omit at least one of its components. For example, without including the sensor module 1400, the RF generator 1000 may obtain electrical data on the load from an external sensor. For another example, without including an alternating current power source 1100 and a rectifier 1200, the RF generator 1000 may receive a direct current power or a rectified direct current power from an external source.

### [Antenna Structure]

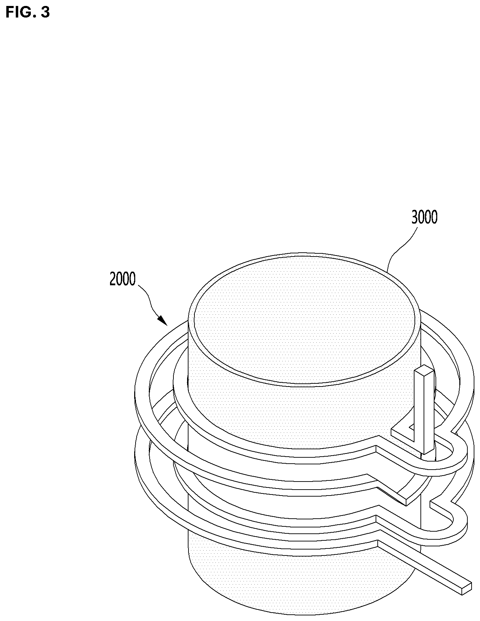

FIG. 3 is a view showing an antenna structure 2000 and a discharging tube 3000 according to an exemplary embodiment.

Referring to FIG. 3, the antenna structure 2000 may be disposed around the discharging tube 3000. For example, the antenna structure 2000 may have a ring shape and may be disposed to surround the discharging tube 3000.

The antenna structure 2000 may be composed of a plurality of turns. For example, the antenna structure 2000 may include a first antenna disposed to surround the discharging tube 3000 with a first radius of curvature on a first plane and a second antenna disposed to surround the first antenna with a second radius of curvature greater than the first radius of curvature on the first plane. The antenna structure 2000 may not be always composed of two turns, and the antenna structure 2000 may be composed of m turns (or m layers, m is a natural number of 1 or more).

The antenna structure 2000 may be composed of a plurality of layers. For example, the antenna structure 2000 may include a first antenna disposed to surround the discharging tube 3000 with a first radius of curvature in a first plane and a second antenna disposed to surround the discharging tube 3000 with the first radius of curvature in a second plane different from the first plane. Herein, the first antenna and the second antenna may have different radii of curvature. The antenna structure 2000 may not be always composed of two layers, and the antenna structure 2000 may be composed of n layers (n is a natural number of 1 or more). In this case, the antenna shape of each layer in the antenna structure 2000 may be substantially the same.

The antenna structure 2000 may be composed of a plurality of turns and a plurality of layers. For example, the antenna structure 2000 may include a first antenna disposed to surround the discharging tube 3000 with a first radius of curvature in a first plane, a second antenna disposed to surround the first antenna with a second radius of curvature greater than the first radius of curvature in the first plane, a third antenna disposed to surround the discharging tube 3000 with the first radius of curvature in the second plane, and a fourth antenna disposed to surround the third antenna with the second radius of curvature in the second plane. Herein, the first antenna and the third antenna may have different radii of curvature, and the second antenna and the fourth antenna may also have different radii of curvature. In this case, the antenna shapes of each layer may be substantially the same.

The antenna structure 2000 may include at least one antenna as described above, and at least each one antenna may include at least one antenna segment. The antenna structure 2000 may vary in the structure or shape depending on the interconnection relationship among a plurality of antenna segments described above. The structure and shape of the antenna structure 2000 will be described later in detail.

Meanwhile, the antenna structure 2000 may be required to increase a discharge holding force and an induced electromotive force necessary for plasma formation depending on the type of a process using plasma. For example, the amount of a reaction gas used in a process may be reduced in order to increase the purity of a process result or in order to reduce a process cost.

In this case, in order to maintain the existing discharge performance, it is necessary to increase the frequency or scale of the electric power applied to the antenna structure 2000, thereby causing problems such as arc faults between antenna segments, breakage of the discharging tube 3000 due to an increase in the voltage of the antenna structure 2000, and an efficiency reduction due to ion losses.

In addition, the size of the discharging tube 3000 may be determined according to the scale or specification of a plasma induction system 100. For example, the diameter of the discharging tube 3000 may be classified as 20 mm or less, 20 mm to 80 mm, 80 mm or more or the like depending on the size of the plasma induction system 100. The magnitude of the electric power applied to the antenna structure 2000 and/or the driving frequency of the electric power may vary in order to induce plasma depending on the diameter of the discharging tube 3000.

At this time, as the diameter of the discharging tube 3000 may increase, the magnitude of the electric power applied to the antenna structure 2000 and/or the driving frequency of the electric power may increase, thereby causing an increase in a voltage in a portion of the antenna structure 2000 adjacent to the discharging tube 3000, and leading to ion losses for plasma generation inside the discharging tube 3000 and damage to the inner wall of the discharging tube 3000.

The problems mentioned above need to be prevented in that the durability, efficiency, and stability of the plasma induction system 100 may be impeded.

In the present disclosure, the configuration and structure of the antenna structure 2000 will be described, which may satisfy the requirements of the plasma process described above and minimize the occurrence of the problems accordingly.

### [Problems of existing antenna structures]

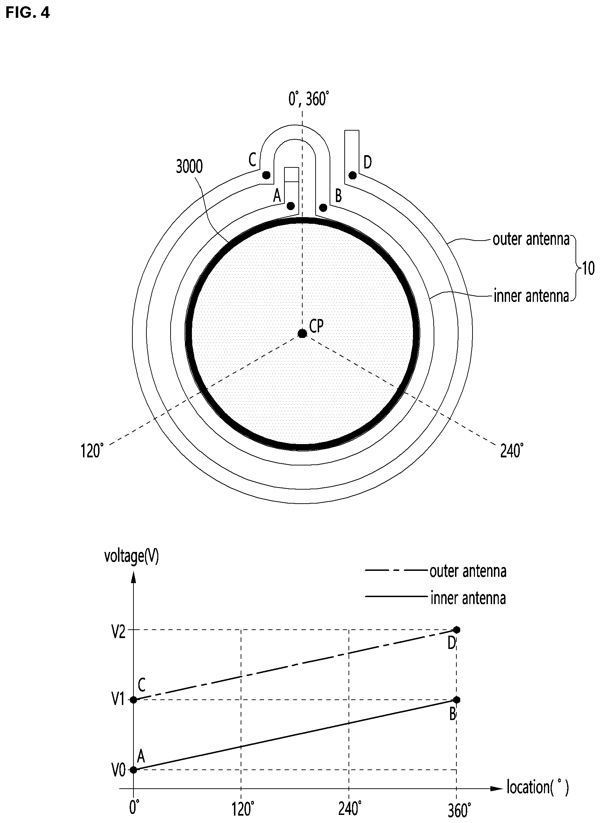

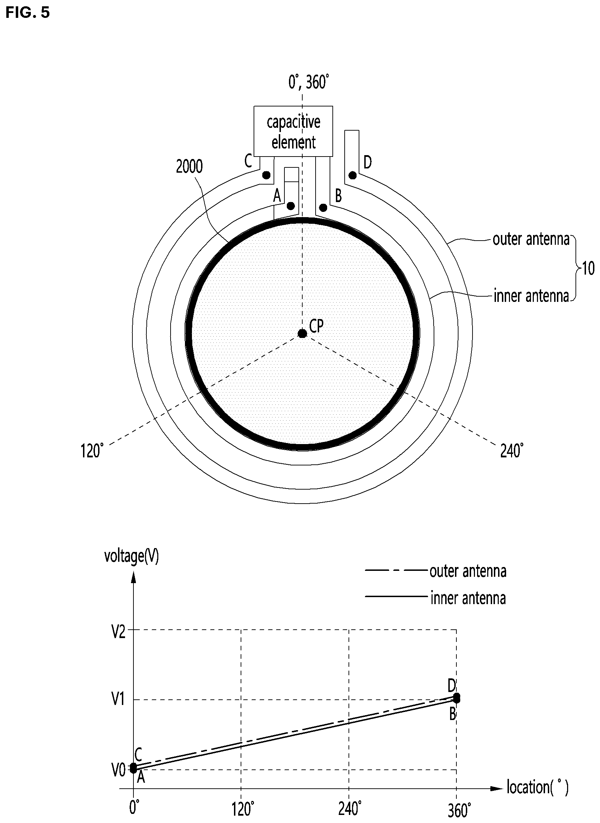

In the following, problems of the existing antenna structures will be described first with reference to FIGS. 4 and 5.

FIGS. 4 and 5 are views respectively showing conventional antenna structures 10, 20. Both FIGS. 4 and 5 show the conventional antenna structures 10 and 20 disposed to surround the discharging tube 3000 and, in particular, show a cross-section perpendicular to the central axis of the discharging tube 3000. In addition, although not shown in FIGS. 4 and 5, the conventional antenna structures 10, 20 are electrically connected to an RF generator 1000. Accordingly, a certain voltage (or electrical current) is applied to the conventional antenna structures 10 and 20, and FIGS. 4 and 5 show a graph of a voltage applied according to a position (the position according to a rotation angle based on a central point (CP)) in the conventional antenna structures 10 and 20.

Referring to FIG. 4, a first conventional antenna structure 10 may include an inner antenna surrounding a discharging tube 3000 and an outer antenna surrounding the inner antenna, and the inner antenna and the outer antenna are connected to each other. Specifically, the inner antenna may extend from point A to point B along the outer diameter surface of the discharging tube 3000, the outer antenna may extend from point C to point D, and point B of the inner antenna and point C of the outer antenna are connected to each other. In addition, although not shown here, point A and point D of the first conventional antenna structure 10 may be respectively connected to both ends of the RF generator 1000, so that the first conventional antenna structure 10 may receive a voltage from the RF generator 1000.

Referring to FIG. 4, when voltage V2 is applied to both ends of the first conventional antenna structure 10 based on the ground voltage V0, voltage V0 to voltage V1 may be applied from point A to point B of the inner antenna of the first conventional antenna structure 10, and voltage V1 to voltage V2 may be applied from point C to point D of the outer antenna of the first conventional antenna structure 10. Here, the voltage V1 may be understood as an intermediate value of a voltage V0 and a voltage V2, and when V0 is 0V, the voltage V1 may correspond to a value of 1/2 of the voltage V2. Thus, when a voltage is applied to the first conventional antenna structure 10, the magnitude of the voltage may increase from the inner antenna to the outer antenna. When the voltage applied to the first conventional antenna structure 10 increases, the voltage applied to the inner antenna and outer antenna also may increase so that an electric field strength formed inside the discharging tube 3000 by the inner antenna may increase and ion losses and damage to the discharging tube 3000 may be unavoidable.

Referring to FIG. 5, a second conventional antenna structure 20 may include an inner antenna surrounding a discharging tube 3000 and an outer antenna surrounding the inner antenna, and the inner antenna and the outer antenna may be connected to each other through a capacitive element. Specifically, the inner antenna extends from point A to point B along the outer diameter surface of the discharging tube 3000, the outer antenna extends from point C to point D, and point B of the inner antenna and point C of the outer antenna are connected to both ends of the capacitive element, respectively. In addition, although not shown here, point A and point D of the second conventional antenna structure 20 may be connected to both ends of the RF generator 1000 so that the second conventional antenna structure 20 may receive a voltage from the RF generator 1000.

The antenna is an inductive element and may have characteristics different from a capacitive element and, in particular, a negative voltage may be applied to the capacitive element when a positive voltage is applied to the antenna by an alternating current power source and a positive voltage may be applied to the capacitive element when a negative voltage is applied to the antenna by an alternating current power source. In other words, a voltage drop may occur in the capacitive element when a voltage rise occurs in the antenna and a voltage rise may occur in the capacitive element when a voltage drop occurs in the antenna. In addition, the capacitive reactance of the capacitive element may be determined on the basis of the inductive reactance of the inner antenna and the inductive reactance of the outer antenna so that the voltage applied to the inner antenna or the outer antenna may correspond to the voltage applied to the capacitive element.

Referring to FIG. 5, when voltage V2 is applied to both ends of the second conventional antenna structure 20 on the basis of the ground voltage V0, voltage V0 to voltage V1 may be applied from point A to point B of the inner antenna of the second conventional antenna structure 20, and voltage V0 to voltage V1 may be applied similarly from point C to point D of the outer antenna of the second conventional antenna structure 20. Here, the voltage V1 may be understood as an intermediate value between the voltage V0 and the voltage V2. A voltage of substantially the same size may be applied to the inner antenna and the outer antenna of the second conventional antenna structure 20 according to a position because a voltage drop or a voltage rise occurs in the capacitive element disposed between the inner antenna and the outer antenna.

However, as the magnitude of the voltage applied to the second conventional antenna structure 20 increases, the magnitude of the voltage applied to the inner antenna also increases, and compared to the first conventional antenna structure 10 of FIG. 4, the intensity of the electric field formed inside the discharging tube 3000 may not change significantly, so the problems of ion losses and damage to the discharging tube 3000 may still remain.

### [New Design - a first exemplary embodiment]

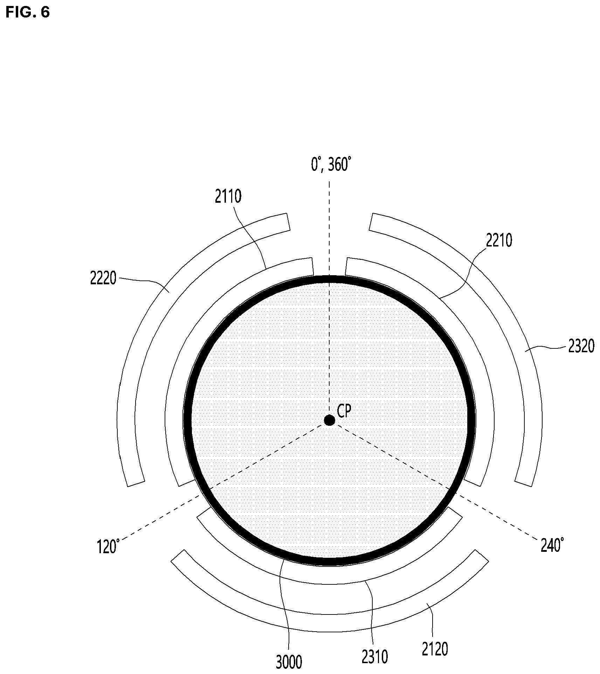

Hereinafter, an antenna structure 2000 according to a first exemplary embodiment in order to reduce the intensity of the electric field formed in the discharging tube 3000 will be described with reference to FIGS. 6 to 9.

As described above, the antenna structure 2000 may be disposed on the outer surface of a discharging tube 3000 and may receive an alternating current power to form an electric field and a magnetic field in the internal space of the discharging tube 3000. In addition, the gas flowing into the discharging tube 3000 may be ionized by the electric field and the magnetic field formed by the antenna structure 2000 and may collide with each other to generate plasma.

The antenna structure 2000 may be implemented in the form of a coil surrounding the discharging tube 3000 as described above. In addition, the antenna structure 2000 may be composed of m turns and n layers, and each turn may include the number of x antenna segments. In the following, for convenience of explanation, the antenna structure 2000 may be composed of two turns and seven layers, and each turn may include three antenna segments, but the technical idea of the present disclosure is not limited thereto.

Each layer of the antenna structure 2000 may include at least an inner antenna located close to the discharging tube 3000 and an outer antenna located further out than the inner antenna based on the discharging tube 3000.

In addition, adjacent layers in the antenna structure 2000 may be electrically connected to each other. For example, an outer antenna of the first layer and an inner antenna of the second layer may be electrically connected to each other among the antenna structures 2000. In this case, adjacent layers in the antenna structure 2000 may be connected through a conductor or an inter-layer capacitive element.

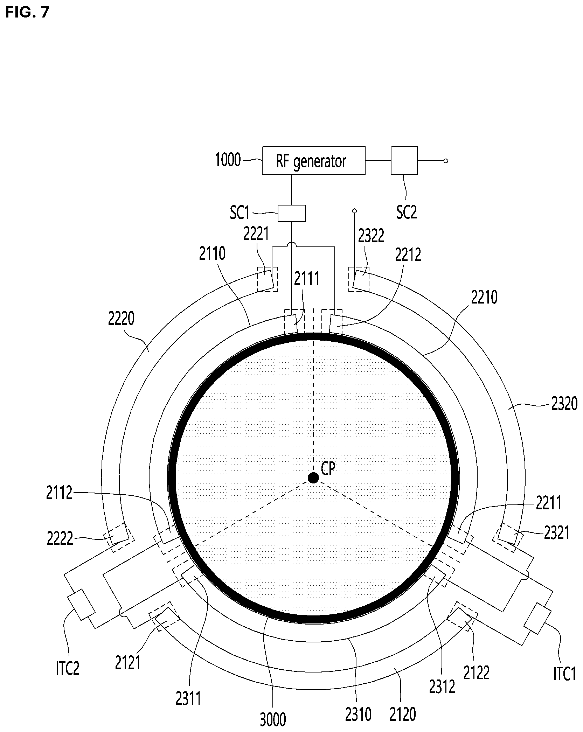

Hereinafter, the shape and structure of each layer of the antenna structure 2000 according to the first exemplary embodiment will be described with reference to FIGS. 6 and 7.

FIG. 6 is a view showing the structure and shape of one layer of an antenna structure 2000 according to the first exemplary embodiment.

One layer of the antenna structure 2000 may be composed of a plurality of antenna segments. For example, the antenna structure 2000 may include a plurality of inner antenna segments and a plurality of outer antenna segments. Specifically, referring to FIG. 6, one layer of the antenna structure 2000 may include a first to third inner antenna segments 2110, 2210, and 2310 and a first to third outer antenna segments 2120, 2220, and 2320.

The first to third inner antenna segments 2110, 2210, and 2310 may be disposed adjacent to the discharging tube 3000 to form an inner antenna. As shown in FIG. 6, the first to third inner antenna segments 2110, 2210, and 2310 may have a radius of curvature corresponding to an outer diameter of the discharging tube 3000 and may be disposed in the same plane, being rotated by 120° relative to the central point (CP) of the discharging tube 3000.

The first to third outer antenna segments 2120, 2220, and 2320 may be disposed to surround the inner antenna to form an outer antenna. For example, as shown in FIG. 6, the first outer antenna segment 2120 may be disposed outside the third inner antenna segment 2310, the second outer antenna segment 2220 may be disposed outside the first inner antenna segment 2110, and the third outer antenna segment 2320 may be disposed outside the second inner antenna segment 2210. The first to third outer antenna segments 2120, 2220, and 2320 may be disposed on the same plane, being rotated by 120° relative to the central point (CP) of the discharging tube 3000.

In FIG. 6, the first to third inner antenna segments 2110, 2210, and 2310 may be disposed while being rotated in a clockwise direction, and the first to third outer antenna segments 2120, 2220, and 2320 may be also disposed while being rotated in a clockwise direction, but the inner antenna segments and outer antenna segments may be disposed while being rotated in a counterclockwise direction. As described later, each of the inner antenna segments and the outer antenna segments may have a radius of curvature, a central angle, and a length, respectively.

The first inner antenna segment 2110 has an arc shape, and the radius of curvature of the first inner antenna segment 2110 may be designed in consideration of the outer diameter of the discharging tube 3000. For example, the radius of curvature of the first inner antenna segment 2110 may be substantially the same as the outer diameter of the discharging tube 3000 so that the first inner antenna segment 2110 is disposed in contact with the discharging tube 3000. For another example, the radius of curvature of the first inner antenna segment 2110 may be greater than the outer diameter of the discharging tube 3000 so that the first inner antenna segment 2110 is disposed and spaced apart as much as a certain distance from the discharging tube 3000.

The second inner antenna segment 2210 has an arc shape, and the radius of curvature of the second inner antenna segment 2210 may be designed in consideration of the outer diameter of the discharging tube 3000. For example, the radius of curvature of the second inner antenna segment 2210 may be substantially the same as the outer diameter of the discharging tube 3000 so that the second inner antenna segment 2210 is disposed in contact with the discharging tube 3000. For another example, the radius of curvature of the second inner antenna segment 2210 may be greater than the outer diameter of the discharging tube 3000 so that the second inner antenna segment 2210 is disposed and spaced apart as much as a certain distance from the discharging tube 3000.

The third inner antenna segment 2310 may have an arc shape, and the radius of curvature of the third inner antenna segment 2310 may be designed in consideration of the outer diameter of the discharging tube 3000. For example, the radius of curvature of the third inner antenna segment 2310 may be substantially the same as the outer diameter of the discharging tube 3000 so that the third inner antenna segment 2310 is disposed in contact with the discharging tube 3000. For another example, the radius of curvature of the third inner antenna segment 2310 may be greater than the outer diameter of the discharging tube 3000 so that the third inner antenna segment 2310 is disposed and spaced apart as much as a certain distance from the discharging tube 3000.

The radii of curvature of the first to third inner antenna segments 2110, 2210, and 2310 may be substantially the same. It is needless to say that the first to third inner antenna segments 2110, 2210, and 2310 may have different radii of curvature.

Each of the first to third inner antenna segments 2110, 2210, and 2310 may have a central angle of 120° or less. Each central angle of the first to third inner antenna segments 2110, 2210, and 2310 may be 90° or more. The central angles of the first to third inner antenna segments 2110, 2210, and 2310 may be substantially the same. It is needless to say that the first to third inner antenna segments 2110, 2210, and 2310 may have central angles of different sizes.

The first to third inner antenna segments 2110, 2210, and 2310 may have substantially the same length. The total sum of the lengths of the first to third inner antenna segments 2110, 2210, and 2310 may be smaller than the length of the circumference whose radius is the radius of curvature of any one of the inner antenna segments. It is needless to say that the first to third inner antenna segments 2110, 2210, and 2310 may have different lengths.

The first outer antenna segment 2120 may have an arc shape, and the radius of curvature of the first outer antenna segment 2120 may be designed in consideration of the radius of curvature of the third inner antenna segment 2310. For example, the radius of curvature of the first outer antenna segment 2120 may be greater than the radius of curvature of the third inner antenna segment 2310 to maintain a predetermined space from the third inner antenna segment 2310.

The second outer antenna segment 2220 may have an arc shape, and the radius of curvature of the second outer antenna segment 2220 may be designed in consideration of the radius of curvature of the first inner antenna segment 2110. For example, the radius of curvature of the second outer antenna segment 2220 may be greater than the radius of curvature of the first inner antenna segment 2110 to maintain a predetermined space from the first inner antenna segment 2110.

The third outer antenna segment 2320 may have an arc shape, and the radius of curvature of the third outer antenna segment 2320 may be designed in consideration of the radius of curvature of the second inner antenna segment 2210. For example, the radius of curvature of the third outer antenna segment 2320 may be greater than the radius of curvature of the second inner antenna segment 2210 to maintain a predetermined space from the second inner antenna segment 2210.

The radii of curvature of the first to third outer antenna segments 2120, 2220, and 2320 may be substantially the same. It is needless to say that the first to third outer antenna segments 2120, 2220, and 2320 may have different radii of curvature.

Each of the first to third outer antenna segments 2120, 2220, and 2320 may have a central angle of 120° or less. Each central angle of the first to third outer antenna segments 2120, 2220, and 2320 may be 90° or more. The central angles of the first to third outer antenna segments 2120, 2220, and 2320 may be substantially the same. It is needless to say that the first to third outer antenna segments 2120, 2220, and 2320 may have central angles of different sizes.

Meanwhile, the central angles of the first to third outer antenna segments 2120, 2220, and 2320 may be smaller than the central angles of the first to third inner antenna segments 2110, 2210, and 2310. Thus, one end of the inner antenna segments or a portion extending therefrom, a portion connecting the antenna segments may be prevented from overlapping with the outer antenna segments.

The first to third outer antenna segments 2120, 2220, and 2320 may have substantially the same length. The total sum of the lengths of the first to third outer antenna segments 2120, 2220, and 2320 may be smaller than the length of the circumference whose radius is the radius of curvature of any one of the outer antenna segments. It is needless to say that the first to third outer antenna segments 2120, 2220, and 2320 may have different lengths from one another.

### [Connection relationship between inner antenna and outer antenna]

FIG. 7 is a view showing a connection relationship among antenna segments in an antenna structure 2000 according to a first exemplary embodiment.

Referring to FIG. 7, a first to third inner antenna segments 2110, 2210, and 2310 may be connected to a first to third outer antenna segments 2120, 2220, and 2320 as follows.

The first inner antenna segment 2110 may be electrically connected to the first outer antenna segment 2120. The other end 2112 of the first inner antenna segment may be electrically connected to one end 2121 of the first outer antenna segment. The other end 2112 of the first inner antenna segment may be connected to one end 2121 of the first outer antenna segment through a first connecting section. Herein, the first connecting section may be implemented in a U-shape, but is not limited thereto.

Meanwhile, one end 2111 of the first inner antenna segment may be electrically connected to one end of the RF generator 1000. In this case, a first auxiliary capacitive element SC1 may be electrically interposed between one end 2111 of the first inner antenna segment and the RF generator 1000.

The first outer antenna segment 2120 may be electrically connected to the second inner antenna segment 2210. The other end 2122 of the first outer antenna segment may be electrically connected to one end 2211 of the second inner antenna segment. The other end 2122 of the first outer antenna segment may be connected to one end 2211 of the second inner antenna segment through a first inter-turn capacitive element (ITC1).

The second inner antenna segment 2210 may be electrically connected to the second outer antenna segment 2220. The other end 2212 of the second inner antenna segment may be electrically connected to one end 2221 of the second outer antenna segment. The other end 2212 of the second inner antenna segment may be connected to one end 2221 of the second outer antenna segment through a second connecting section. Herein, the second connecting section may be implemented in a U-shape, but is not limited thereto.

The second outer antenna segment 2220 may be electrically connected to the third inner antenna segment 2310. The other end 2222 of the second outer antenna segment may be electrically connected to one end 2311 of the third inner antenna segment. The other end 2222 of the second outer antenna segment may be connected to one end 2311 of the third inner antenna segment through a second inter-turn capacitive element (ITC2).

The third inner antenna segment 2310 may be electrically connected to the third outer antenna segment 2320. The other end 2312 of the third inner antenna segment may be electrically connected to one end 2321 of the third outer antenna segment. The other end 2312 of the third inner antenna segment may be connected to one end 2321 of the third outer antenna segment through a third connecting section. Herein, the third connecting section may be implemented in a U-shape, but is not limited thereto.

Meanwhile, the other end 2322 of the third outer antenna segment may be electrically connected to an antenna segment of another layer. However, when the antenna structure 2000 is configured as one layer, the other end 2322 of the third outer antenna segment may be electrically connected to the other end of the RF generator 1000. In this case, a second auxiliary capacitive element SC2 may be electrically interposed between the other end 2322 of the third outer antenna segment and the RF generator 1000. However, any one of the first auxiliary capacitive element SC1 and the second auxiliary capacitive element SC2 may be omitted.

When antenna segments in the antenna structure 2000 are connected as described above, the first inner antenna segment 2110, the first outer antenna segment 2120, the first inter-turn capacitive element ITC1, the second inner antenna segment 2210, the second outer antenna segment 2220, the second inter-turn capacitive element ITC2, the third inner antenna segment 2310, and the third outer antenna segment 2320 may be connected in series in that order on the basis of the RF generator 1000.

The first outer antenna segment 2120 and the first inter-turn capacitive element (ITC1) are electrically interposed between the first inner antenna segment 2110 and the second inner antenna segment 2210.

In addition, the second outer antenna segment 2220 and the second inter-turn capacitive element (ITC2) may be electrically interposed between the second inner antenna segment 2210 and the third inner antenna segment 2210.

In addition, the second inter-turn capacitive element (ITC2) and the third inner antenna segment 2310 may be electrically interposed between the second outer antenna segment 2220 and the third outer antenna segment 2320.

### [New antenna structure voltage]

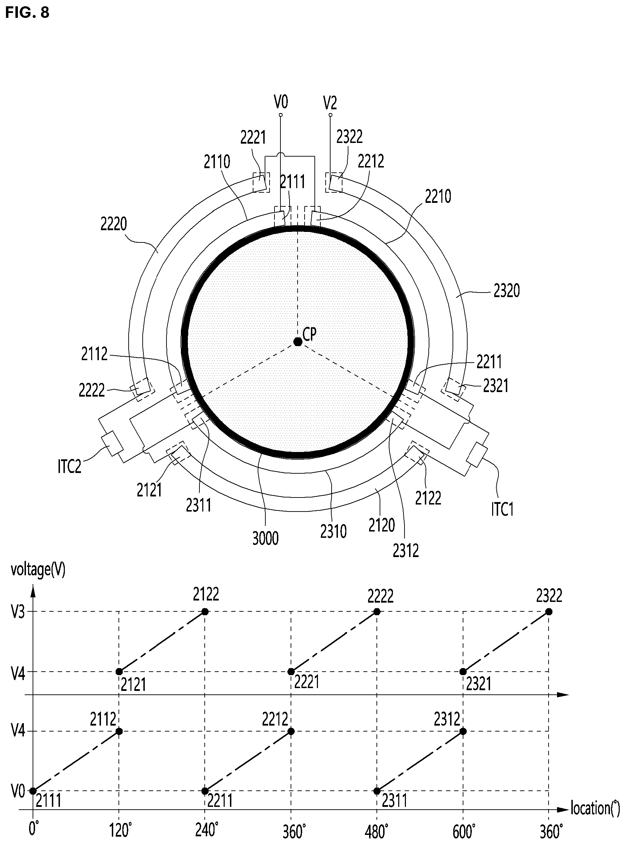

Hereinafter, a voltage applied to antenna segments within an antenna structure 2000 will be described with reference to FIG. 8.

FIG. 8 is a view showing a voltage according to a position within the antenna structure 2000 according to an exemplary embodiment.

Referring to FIG. 8, the antenna structure 2000 may be implemented in a form in which a first inner antenna segment 2110, a first outer antenna segment 2120, a first inter-turn capacitive element ITC1, a second inter antenna segment 2210, a second outer antenna segment 2220, a second inter-turn capacitive element ITC2, a third inner antenna segment 2310, and a third outer antenna segment 2320 are sequentially connected in series in that order as described in FIGS. 6 and 7.

Meanwhile, it is assumed that a voltage V2 is applied to both ends of the antenna structure 2000 on the basis of voltage V0 in order to compare with the conventional antenna structures 10 and 20 of FIGS. 4 and 5. In addition, it is assumed that the voltage applied to each antenna segment in the antenna structure 2000 is substantially the same and that the inductance of the antenna segments and the capacitance of the inter-turn capacitive elements are appropriately selected such that the total sum of the raised voltages in the antenna segments corresponds to the total sum of the dropped voltages in the inter-turn capacitive elements, or the total sum of the dropped voltages in the antenna segments corresponds to the total sum of the raised voltages in the inter-turn capacitive elements. For example, the values of the total composite inductance of antenna segments and the total composite capacitance of capacitive elements may be set to satisfy the condition that the resonance frequency becomes the basic driving frequency.

Referring to FIG. 8, a voltage V4 may be applied to both ends of the first to third inner antenna segments 2110, 2210, and 2310 on the basis of voltage V0. In addition, voltage V3 may be applied to both ends of the first to third outer antenna segments 2120, 2220, and 2320 on the basis of voltage V4.

When voltage V0 is 0V for convenience of calculation, voltage V3 may be a value corresponding to 1/3 of voltage V2, and this is because a layer antenna is divided into three parts based on the inter-turn capacitive element and substantially the same voltage is distributed to each part.

In addition, voltage V4 may be a value corresponding to the intermediate value of voltage V3 and voltage V0, and this is because the same voltage is substantially applied to the inner antenna segments and outer antenna segments. This means that the voltage V4 is a value corresponding to 1/6 of the voltage V2 when the voltage V0 is 0V.

Meanwhile, voltage V3 may be understood as a value lower than the voltage V1 in that the voltage V1 corresponds to a value of 1/2 of the voltage V2 in a conventional antenna structure. Furthermore, the maximum value of the voltage applied to the first to third inner antenna segments 2110, 2210, and 2310 constituting the inner antenna is V4, which is likewise significantly lower than the maximum value, V1 of the voltage applied to the inner antenna in the conventional antenna structures 10 and 20.

As a result, when comparing the antenna structure 2000 according to an exemplary embodiment of the present disclosure and the conventional antenna structures 10 and 20, the electric potential difference generated among the antenna segments of the antenna structure 2000 may be lowered, arcing within the antenna structure 2000 may be prevented, ion losses for plasma induction may be lowered, the degree of wear and tear on the inner surface of the discharging tube 3000 adjacent to the antenna structure 2000 due to ion bombardment may be reduced, and parasitic resistance between the antenna segments may be reduced, thereby increasing the reliability and efficiency of a system.

### [Connection of layers_in series]

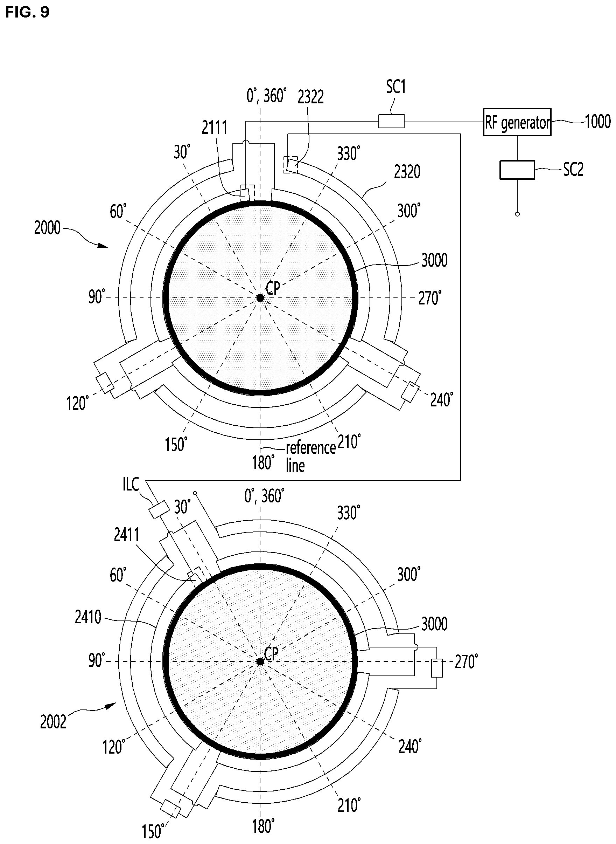

Hereinafter, a method of arranging layer antennas located on different layers in an antenna structure 2000 and a process of connecting layer antennas to each other will be described with reference to FIG. 9.

FIG. 9 is a view showing layer antennas of the antenna structure 2000 according to an exemplary embodiment.

A layer antenna may refer to an antenna disposed on each layer when an antenna structure 2000 may be composed of a plurality of layers, and may include a plurality of antenna segments described in FIG. 6, while each antenna segment is connected in a way described in FIG. 7.

The antenna structure 2000 according to an exemplary embodiment of the present disclosure may be composed of a plurality of layers and may include a layer antenna disposed in each layer. Hereinafter, for convenience of explanation, a method of connecting two adjacent layer antennas to each other will be described, and other layer antennas may also be connected in the same manner.

Referring to FIG. 9, the antenna structure 2000 may include at least a first layer antenna 2001 and a second layer antenna 2002.

The first layer antenna 2001 and the second layer antenna 2002 may be electrically connected to each other. For example, any one of the outer antenna segments of the first layer antenna 2001 and any one of the inner antenna segments of the second layer antenna 2002 may be electrically connected to each other. Specifically, the third outer antenna segment 2320 of the first layer antenna 2001 and the fourth inner antenna segment 2410 of the second layer antenna 2002 may be electrically connected to each other. In this case, the other end 2322 of the third outer antenna segment of the first layer antenna may be electrically connected to one end 2411 of the fourth inner antenna segment of the second layer antenna.

The first layer antenna 2001 and the second layer antenna 2002 may be connected to each other through a capacitive element. For example, an inter-layer capacitive element (ILC) may be electrically interposed between the other end 2322 of the third outer antenna segment of the first layer antenna and one end 2411 of the fourth inner antenna segment of the second layer antenna.

The first layer antenna 2001 and the second layer antenna 2002 may be connected to each other through a conductor.

The second layer antenna 2002 and the third layer antenna may be electrically connected to each other by using a method of connecting the first layer antenna 2001 and the second layer antenna 2002. Likewise, the third layer antenna and the fourth layer antenna, the fourth layer antenna and the fifth layer antenna, the fifth layer antenna and the sixth layer antenna, and the sixth layer antenna and the seventh layer antenna may be electrically connected respectively.

The first to seventh layer antennas may be disposed on the first to seventh planes, respectively. The spacing between the first to seventh planes may be set to be the same. Alternatively, the spacing between the first to seventh planes may be set to be different as needed.

Each of the first layer antenna 2001 and the seventh layer antenna may be electrically connected to the RF generator 1000. For example, one end 2111 of the first inner antenna segment of the first layer antenna may be electrically connected to one end of the RF generator 1000, and the other end of the third outer antenna segment of the seventh layer antenna may be electrically connected to the other end of the RF generator 1000. In this case, a first auxiliary capacitive element (SC1) may be electrically interposed between one end 2111 of the first inner antenna segment of the first layer antenna and the RF generator 1000. In addition, a second auxiliary capacitive element (SC2) may be electrically interposed between the other end of the third outer antenna segment of the seventh layer antenna and the other end of the RF generator 1000. However, any one of the first auxiliary capacitive element SC1 and the second auxiliary capacitive element SC2 may be omitted.

As described above, each layer antenna in the antenna structure 2000 may include at least two inter-turn capacitive elements. Meanwhile, the inter-turn capacitive element may be relatively bulky when compared to the layer antenna. For example, an inter-turn capacitive element may have a preset height in the longitudinal direction of the discharging tube 3000, and the height of the inter-turn capacitive element may be greater than the distance between layer antennas or the spacing between the planes in which each layer antenna is disposed.

When the height of the inter-turn capacitive element is relatively large, and the adjacent layer antenna is disposed in phase, the distance between the inter-turn capacitive elements may become narrow, resulting in interference or physical collision. Therefore, layer antennas may need to be disposed according to a certain rule as described later.

The adjacent layer antennas of the antenna structure 2000 may be disposed to be spaced apart from each other as much as a preset rotation angle. Referring to FIG. 8, the second layer antenna 2002 may be disposed to be rotated by about 30° with respect to the first layer antenna 2001. Specifically, the second layer antenna 2002 may be rotated by about 30° based on the reference line when the first layer antenna 2001 is rotated by 0° based on a reference line.

Likewise, layer antennas adjacent to each other among the first to seventh layer antennas may be disposed in a state to be spaced apart from each other as many as 30° with respect to the reference line. Accordingly, the inter-turn capacitive elements of each layer antenna may be prevented from colliding or interfering with each other. Specifically, when layer antennas are disposed according to the rules described above, the inter-turn capacitive elements of the first layer antenna 2001 may be rotated by about 120° and about 240°, respectively, based on the reference line, and the inter-turn capacitive elements of the fifth layer antenna may be disposed while being rotated by about 240° and about 360°, respectively. Here, the inter-turn capacitive element rotated by about 240° on the basis of the reference line in the first layer antenna and the inter-turn capacitive element rotated by about 240° on the basis of the reference line in the fifth layer antenna may be in phase with each other, but the first layer antenna and the fifth layer antenna may be sufficiently spaced apart from each other enough to prevent interference or physical collision between the inter-turn capacitive element of the first layer antenna and the inter-turn capacitive element of the fifth layer antenna.

The rotation angle at which the adjacent layer antenna may be spaced apart from each other may be determined on the basis of the size of the inter-turn capacitive element (e.g., height), the separation distance between the layer antennas (or the spacing between the planes in which the layer antennas are disposed), the number of antenna segments constituting each turn of the layer antenna, and/or the size of the layer antenna (e.g., a thickness of the antenna segment).

For example, when the number of antenna segments constituting each turn in the layer antenna is x, the rotation angle may be determined to be (180/x)° or less. Specifically, when the height of the inter-turn capacitive element is more than twice the separation distance between the layer antennas and the number of antenna segments constituting each turn of the layer antenna is 3, the rotation angle may be determined to be less than 60°.

As another example, when the number of layer antennas constituting the antenna structure 2000 is y, the rotation angle may be determined to be (180/(y-1))° or less. Specifically, when the number of layer antennas constituting the antenna structure 2000 is 7, the rotation angle may be determined to be 30° or less.

When layer antennas within the antenna structure 2000 are connected as described above, all components of the antenna structure 2000 in a serial connection state may be electrically connected to the RF generator 1000.

At this time, in the first layer antenna 2001, a voltage is distributed as described in FIG. 8, and the voltage applied to the inner antenna segments adjacent to the discharging tube 3000 may be relatively low.

In addition, voltage distribution may be made in the second layer antenna 2002 as described in FIG. 8 by connecting the first layer antenna 2001 and the second layer antenna 2002 to each other through an inter-layer capacitive element (ILC) just as the outer antenna segment and the inner antenna segment are connected to each other through an inter-turn capacitive element in the first layer antenna 2001.

As a result, the voltage applied to the inner antenna segments of each layer antenna in the antenna structure 2000 may be relatively low, thereby preventing ion losses or damage to the inner wall of the discharging tube 3000 as described above, and improving the durability, efficiency, and stability of a plasma induction system 100.

### [Connection of layers in parallel]

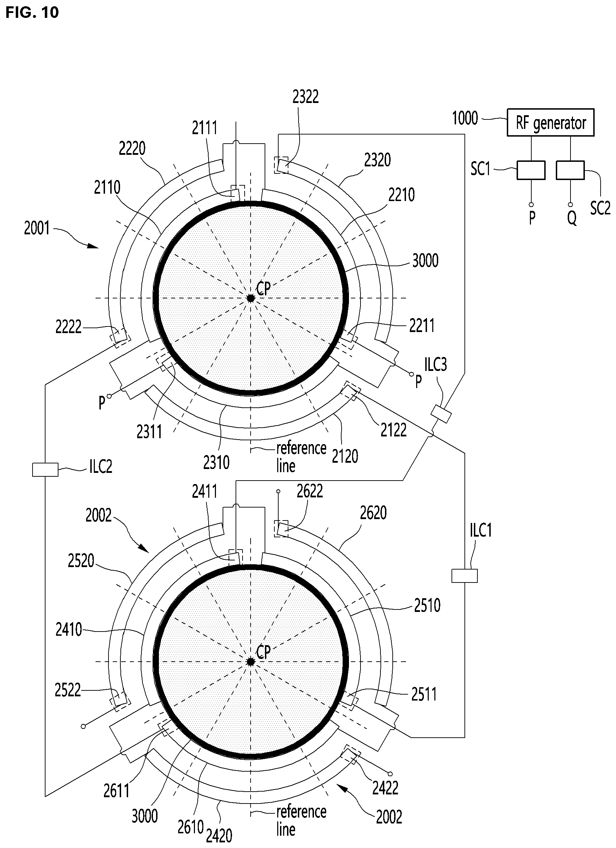

In the following, another method of connecting layer antennas located on different layers in an antenna structure 2000 will be described with reference to FIG. 10.

As described in FIG. 9, a layer antenna may refer to an antenna disposed on each layer when an antenna structure 2000 is composed of a plurality of layers and may include a plurality of antenna segments described in FIG. 6, and each antenna segment may be connected with one another in a way described in FIG. 7.

Hereinafter, for convenience of explanation, a method of connecting two adjacent layer antennas to each other will be described, and other layer antennas may also be connected in the same manner.

Referring to FIG. 10, the antenna structure 2000 may include at least a first layer antenna 2001 and a second layer antenna 2002.

The first layer antenna 2001 may include the first to third inner antenna segments 2110, 2210, and 2310 constituting an inner antenna and the first to third outer antenna segments 2120, 2220, and 2320 constituting an outer antenna. The second layer antenna 2002 may include a fourth to sixth inner antenna segments 2410, 2510, and 2610 constituting an inner antenna and a fourth to sixth outer antenna segments 2420, 2520, and 2620 constituting an outer antenna.

The antenna structure 2000 may further include a first to third inter-layer capacitive elements ILC1, ILC2, and ILC3 interposed among layer antennas.

The first layer antenna 2001 and the second layer antenna 2002 may be electrically connected to each other. For example, any one antenna segment of the first layer antenna 2001 may be electrically connected to a corresponding antenna segment of the second layer antenna 2002. Specifically, the outer antenna segments of the first layer antenna 2001 and the inner antenna segments of the second layer antenna 2002 may be connected on a one-to-one basis.

The first layer antenna 2001 and the second layer antenna 2002 may be connected in parallel as follows.

First, the first outer antenna segment 2120 of the first layer antenna 2001 may be electrically connected to the fifth inner antenna segment 2510 of the second layer antenna 2002. Specifically, the other end 2122 of the first outer antenna segment and one end 2511 of the fifth inner antenna segment may be electrically connected to each other.

A first inter-layer capacitive element (ILC1) may be electrically interposed between the other end 2122 of the first outer antenna segment and one end 2511 of the fifth inner antenna segment. In other words, the first outer antenna segment 2120 and the fifth inner antenna segment 2510 may be connected to each other through the first inter-layer capacitive element (ILC1).

Meanwhile, when one end 2111 of the first inner antenna segment is electrically connected to one end of a RF generator 1000 and the other end 2522 of the fifth outer antenna segment is electrically connected to the other end of the RF generator 1000, the RF generator 1000, the first inner antenna segment 2110, the first outer antenna segment 2120, the first inter-layer capacitive element ILC1, the fifth inner antenna segment 2510, and the fifth outer antenna segment 2520 may constitute a first closed circuit.

Alternatively, when the antenna structure 2000 is implemented in three or more layers, the fifth outer antenna segment 2520 may be electrically connected to the inner antenna segment on the next layer in the same way, and similarly, the corresponding antenna segments on each layer may be electrically connected. Eventually, the outer antenna segment of the last layer may be electrically connected to the RF generator 1000 to constitute a first closed circuit.

The second outer antenna segment 2220 of the first layer antenna 2001 may be electrically connected to the sixth inner antenna segment 2610 of the second layer antenna 2002. Specifically, the other end 2222 of the second outer antenna segment and one end 2611 of the sixth inner antenna segment may be electrically connected to each other.

A second inter-layer capacitive element (ILC2) may be electrically interposed between the other end 2222 of the second outer antenna segment and one end 2611 of the sixth inner antenna segment. In other words, the second outer antenna segment 2220 and the sixth inner antenna segment 2610 may be connected to each other through the second inter-layer capacitive element (ILC2).

Meanwhile, when one end 2211 of the second inner antenna segment is electrically connected to one end of the RF generator 1000 and the other end 2622 of the sixth outer antenna segment is electrically connected to the other end of the RF generator 1000, the RF generator 1000, the second inner antenna segment 2210, the second outer antenna segment 2220, the second inter-layer capacitive element ILC2, the sixth inner antenna segment 2610, and the sixth outer antenna segment 2620 may be sequentially connected in series to constitute a second closed circuit.

Alternatively, when the antenna structure 2000 is implemented in three or more layers, the sixth outer antenna segment 2620 is electrically connected to the corresponding inner antenna segment on the next layer in the same way, and similarly, the corresponding antenna segments on each layer may be electrically connected with one another. Eventually, the outer antenna segment of the last layer may be electrically connected to the RF generator 1000 to constitute a second closed circuit.

The third outer antenna segment 2320 of the first layer antenna 2001 may be electrically connected to the fourth inner antenna segment 2410 of the second layer antenna 2002. Specifically, the other end 2322 of the third outer antenna segment and one end 2411 of the fourth inner antenna segment may be electrically connected to each other.

A third inter-layer capacitive element (ILC3) may be electrically interposed between the other end 2322 of the third outer antenna segment and one end 2411 of the fourth inner antenna segment. In other words, the third outer antenna segment 2320 and the fourth inner antenna segment 2410 may be connected to each other through the third inter-layer capacitive element ILC3.

Meanwhile, when one end 2311 of the third inner antenna segment is electrically connected to one end of the RF generator 1000 and the other end 2422 of the fourth outer antenna segment is electrically connected to the other end of the RF generator 1000, the RF generator 1000, the third inner antenna segment 2310, the third outer antenna segment 2320, the third inter-layer capacitive element ILC3, the fourth inner antenna segment 2410, and the fourth outer antenna segment 2420 may constitute a first closed circuit.

Alternatively, when the antenna structure 2000 is implemented in three or more layers, the fourth outer antenna segment 2420 may be electrically connected to the inner antenna segment on the next layer in the same way, and similarly, the corresponding antenna segments on each layer may be electrically connected to each other. Eventually, the outer antenna segment of the last layer may be electrically connected to the RF generator 1000 to constitute a third closed circuit.

A plurality of closed circuits may be formed between the antenna structure 2000 and the RF generator 1000. Herein, the number of closed circuits to be formed may be the same as the number of antenna segments constituting one turn. For example, when one turn of the antenna structure 2000 consists of three antenna segments as described above, a first to third closed circuits may be formed between the antenna structure 2000 and the RF generator 1000, and each closed circuit may be connected in parallel with each other based on the RF generator 1000.

At this time, when looking at each closed circuit, it may be observed that a sequential connection of the inner antenna segment, the outer antenna segment, and the capacitive element is repeated according to the number of layers. This eventually may mean that the voltage distribution described in FIG. 8 is achieved in each closed circuit, and furthermore, it may mean that a relatively low voltage is applied to the inner antenna segment.

As a result, the voltage applied to the inner antenna segments of each layer antenna may be relatively low, thereby preventing ion losses or damage to the inner wall of the discharging tube 3000, and improving the durability, efficiency, and stability of a plasma induction system 100.

As described above, antenna segments may be connected to each other in series in order to make one closed circuit and in parallel in order to make a plurality of closed circuits. In a serial connection method and a parallel connection method, the resonance condition according to the total inductance and total capacitance of the antenna structure 2000 may not change significantly, so the driving frequency of the electric power applied to the antenna structure 2000 may not change significantly. Meanwhile, although the impedance in a view of the antenna structure 2000 from the RF generator 1000 changes depending on a connection method. Accordingly, even though the same power is applied to the antenna structure 2000, the amount of electrical current flowing to the antenna structure 2000 may vary. For example, when the antenna structure 2000 has the same layer and the same turns, a parallel connection method may have a smaller resistance component than a series connection method, so the parallel connection method may be adopted when higher power consumption is preferable with the same input voltage.

However, unlike what is described in FIG. 9, any one layer antenna of the antenna structure 2000 may be disposed in an in-phase manner with another adjacent layer antenna. For example, referring to FIG. 10, when the antenna structure 2000 is composed of seven layers, a first layer antenna 2001 and a second layer antenna 2002 may maintain the same angle (e.g., 0°) with respect to the reference line. Meanwhile, as described in FIG. 9, it is also possible for adjacent layer antennas in the antenna structure 2000 to be spaced apart from each other as much as a preset rotation angle.

### [New design - second exemplary embodiment]

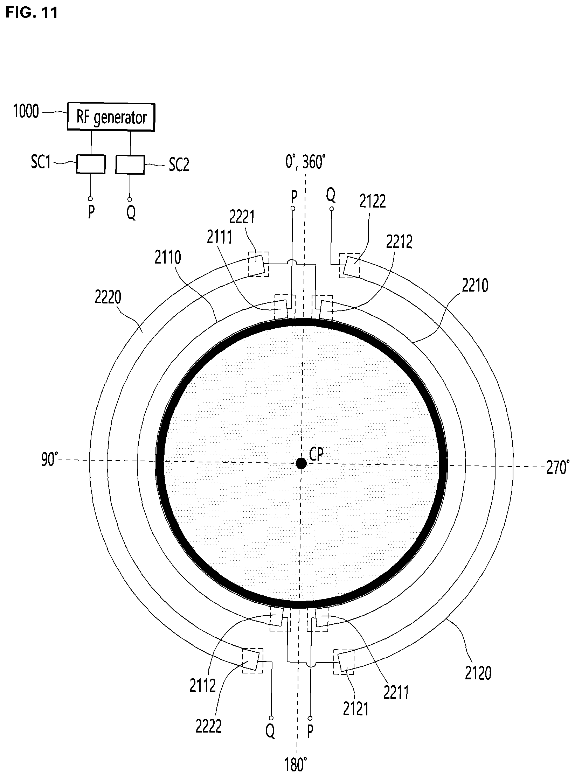

Hereinafter, another type of antenna structure 2000 will be described with reference to FIG. 11. Unless otherwise stated below, the content of the antenna structure 2000 according to the first exemplary embodiment described in FIGS. 6 to 9 may be applied in the same manner.

FIG. 11 is a view showing an antenna structure 2000 according to a second exemplary embodiment.

Referring to FIG. 11, the antenna structure 2000 may include a first inner antenna segment 2110, a second inner antenna segment 2210, a first outer antenna segment 2120, and a second outer antenna segment 2220. The first and second inner antenna segments 2110 and 2120 may constitute an inner antenna, and the first and second outer antenna segments 2120, 2220 may constitute an outer antenna.

Each of the first and second inner antenna segments 2110 and 2210 may have a central angle of 180° or less. A central angle of each first and second inner antenna segments 2110, 2210 may be 120° or more. It is needless to say that the first and second inner antenna segments 2110 and 2210 may have central angles of different sizes.

Each of the first and second outer antenna segments 2120 and 2220 may have a central angle of 180° or less. A central angle of each first and second outer antenna segments 2120 and 2220 may be 120° or more. It is needless to say that the first and second outer antenna segments 2120 and 2220 may have central angles of different sizes.

Meanwhile, the central angles of the first and second outer antenna segments 2120 and 2220 may be smaller than the central angles of the first and second inner antenna segments 2110 and 2210. Thereby, one end of the inner antenna segments or a portion extending therefrom, and a portion connecting the antenna segments may be prevented from overlapping with the outer antenna segments.

In the antenna structure 2000 according to the second exemplary embodiment, antenna segments may be connected to a RF generator 1000 in parallel as follows.

The first inner antenna segment 2110 may be electrically connected to the RF generator 1000 and the first outer antenna segment 2120. Specifically, one end 2111 of the first inner antenna segment may be electrically connected to one end of the RF generator 1000, and the other end 2112 of the first inner antenna segment may be connected to one end 2121 of the first outer antenna segment. In this case, a first auxiliary capacitive element SC1 may be electrically interposed between one end 2111 of the first inner antenna segment and one end of the RF generator 1000.

The first outer antenna segment 2120 may be electrically connected to the RF generator 1000 and the first inner antenna segment 2110. Specifically, one end 2121 of the first outer antenna segment may be connected to the other end 2112 of the first inner antenna segment, and the other end 2122 of the first outer antenna segment may be connected to the other end of the RF generator 1000. In this case, a second capacitive element SC2 may be electrically interposed between the other end 2122 of the first outer antenna segment and the other end of the RF generator 1000.

The second inner antenna segment 2210 may be electrically connected to the RF generator 1000 and the second outer antenna segment 2220. Specifically, one end 2211 of the second inner antenna segment may be connected to one end of the RF generator 1000, and the other end 2212 of the second inner antenna segment may be connected to one end 2221 of the second outer antenna segment. In this case, a first auxiliary capacitive element SC1 may be electrically interposed between one end 2211 of the second inner antenna segment and one end of the RF generator 1000.

The second outer antenna segment 2220 may be connected to the RF generator 1000 and the second inner antenna segment 2210. Specifically, one end 2221 of the second outer antenna segment may be connected to the other end 2212 of the second inner antenna segment, and the other end 2222 of the second outer antenna segment may be connected to the other end of the RF generator 1000. In this case, a second auxiliary capacitive element SC2 may be electrically interposed between the other end 2222 of the second outer antenna segment and the other end of the RF generator 1000.

Although a case where the antenna structure 2000 according to the second exemplary embodiment is implemented as a single layer has been described above, the technical idea of the present disclosure is not limited thereto, and the antenna structure 2000 according to the second exemplary embodiment may include a plurality of layer antennas and each layer antenna may be designed with the structure described above. In this case, each layer antenna may be connected by the method described in FIG. 9 or 10. For example, the other end 2122 of the first outer antenna segment may be electrically connected to one end of any inner antenna segment of another layer through the first inter-layer capacitive element ILC1, and the other end 2222 of the second outer antenna segment may also be electrically connected to one end of any inner antenna segment of another layer through the second inter-layer capacitive element ILC2.

As described above, the RF generator 1000, the first inner antenna segment 2110, and the first outer antenna segment 2120 may constitute one closed circuit, and the RF generator 1000, the second inner antenna segment 2210, and the second outer antenna segment 2220 may constitute another closed circuit. In other words, the antenna structure 2000 and the RF generator 1000 may form a parallel circuit.

When the number of turns of the antenna structure 2000 is even and the number of antenna segments constituting each turn is even, the antenna structure 2000 and the RF generator 1000 may be connected in parallel to have at least two or more closed circuits.

In such a parallel connection structure, the resistance component of the antenna structure 2000 may be lowered as described above, so that power consumption may be greatly taken even with a low applied voltage. In particular, in the case of the second exemplary embodiment, the antenna structure 2000 may be configured in a serial connection method, but it may be specialized in a parallel connection method. More specifically, in the antenna structure 2000 according to the second exemplary embodiment, not only antenna segments in each layer are symmetrical, but also antenna segments in all layers are symmetrical, so impedance may be stably managed even when the plasma induced in the discharging tube 3000 is biased to any side.

Furthermore, when the antenna structure 2000 and the RF generator 1000 are electrically connected through the parallel connection structure mentioned above, the voltage applied to the inner antenna adjacent to the discharging tube 3000 may be relatively lowered without using the capacitive element.

For example, when a voltage V2 based on a voltage V0 is applied to the antenna structure 2000 through both ends P and Q of the RF generator 1000 in FIG. 10, a voltage V0 to a voltage V1 may be applied to the first and second inner antenna segments 2110 and 2210, and a voltage V1 to a voltage V2 may be applied to the first and second outer antenna segments 2210 and 2220.

### [New design - third exemplary embodiment]

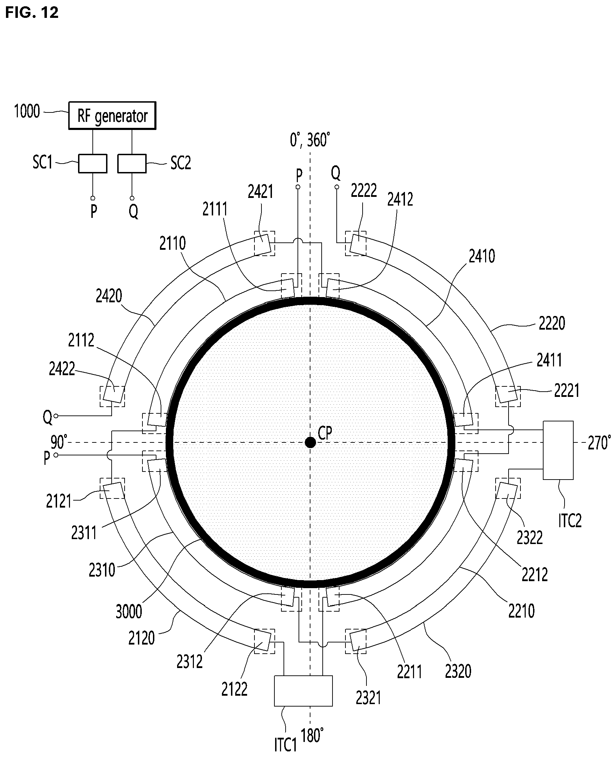

Hereinafter, another type of an antenna structure 2000 will be described with reference to FIG. 12. Unless otherwise stated below, the content of the antenna structure 2000 according to the first exemplary embodiment described in FIGS. 6 to 9 may be applied in the same manner.

FIG. 12 is a view showing an antenna structure 2000 according to a third exemplary embodiment.

Referring to FIG. 12, the antenna structure 2000 may include a first to fourth inner antenna segments 2110, 2210, 2310, and 2410 constituting an inner antenna, a first to fourth outer antenna segments 2120, 2220, 2320, and 2420 constituting an outer antenna, and a first and second inter-turn capacitive elements ITC1 and ITC2.

Each first to fourth inner antenna segments 2110, 2210, 2310, and 2410 may have a central angle of 90° or less. A central angle of each first to fourth inner antenna segments 2110, 2210, 2310, and 2410 may be 72° or more. The first to fourth inner antenna segments 2110, 2210, 2310, and 2410 may have central angles of different sizes.

Each first to fourth outer antenna segments 2120, 2220, 2320, and 2420 may have a central angle of 90° or less. A central angle of each first to fourth outer antenna segments 2120, 2220, 2320, and 2420 may be 72° or more. The first to fourth outer antenna segments 2120, 2220, 2320, and 2420 may have central angles of different sizes.

Meanwhile, the central angles of the first to fourth outer antenna segments 2120, 2220, 2320, and 2420 may be smaller than the central angles of the first to fourth inner antenna segments 2110, 2210, 2310, and 2410. Thereby, one end of the inner antenna segments or a portion extending therefrom, and a portion connecting the antenna segments may be prevented from overlapping with the outer antenna segments.

In the antenna structure 2000 according to the third exemplary embodiment, antenna segments may be connected to the RF generator 1000 in parallel as follows.

The first inner antenna segment 2110 may be electrically connected to the RF generator 1000 and the first outer antenna segment 2120. Specifically, one end 2111 of the first inner antenna segment may be electrically connected to one end of the RF generator 1000, and the other end 2112 of the first inner antenna segment may be connected to one end 2121 of the first outer antenna segment. In this case, a first auxiliary capacitive element SC1 may be electrically interposed between one end 2111 of the first inner antenna segment and one end of the RF generator 1000.

The first outer antenna segment 2120 may be electrically connected to the second inner antenna segment 2210. Specifically, the other end 2122 of the first outer antenna segment may be electrically connected to one end 2211 of the second inner antenna segment. In this case, a first inter-turn capacitive element (ITC1) may be electrically interposed between the other end 2122 of the first outer antenna segment and one end 2211 of the second inner antenna segment.

The second inner antenna segment 2210 may be electrically connected to the second outer antenna segment 2220. Specifically, the other end 2212 of the second inner antenna segment may be connected to one end 2221 of the second outer antenna segment.

The second outer antenna segment 2220 may be electrically connected to the RF generator 1000. Specifically, the other end 2222 of the second outer antenna segment may be electrically connected to the other end of the RF generator 1000. In this case, a second auxiliary capacitive element SC2 may be electrically interposed between the other end 2222 of the second outer antenna segment and the other end of the RF generator 1000.

The third inner antenna segment 2310 may be electrically connected to the RF generator 1000 and the third outer antenna segment 2320. Specifically, one end 2311 of the third inner antenna segment may be electrically connected to one end of the RF generator 1000, and the other end 2312 of the third inner antenna segment may be connected to one end 2321 of the third outer antenna segment. In this case, a first auxiliary capacitive element SC1 may be electrically interposed between one end 2311 of the third inner antenna segment and one end of the RF generator 1000.

The third outer antenna segment 2320 may be electrically connected to the fourth inner antenna segment 2410. Specifically, the other end 2322 of the third outer antenna segment may be electrically connected to one end 2411 of the fourth inner antenna segment. In this case, a second inter-turn capacitive element (ITC2) may be electrically interposed between the other end 2322 of the third outer antenna segment and one end 2411 of the fourth inner antenna segment.

The fourth inner antenna segment 2410 may be electrically connected to the fourth outer antenna segment 2420. Specifically, the other end 2412 of the fourth inner antenna segment may be connected to one end 2421 of the fourth outer antenna segment.

The fourth outer antenna segment 2420 may be electrically connected to the RF generator 1000. Specifically, the other end 2422 of the fourth outer antenna segment may be electrically connected to the other end of the RF generator 1000. In this case, a second auxiliary capacitive element SC2 may be electrically interposed between the other end 2422 of the fourth outer antenna segment and the other end of the RF generator 1000.

Although a case where the antenna structure 2000 according to the third exemplary embodiment is implemented as a single layer is described above, the technical idea of the present disclosure is not limited thereto, and the antenna structure 2000 according to the third exemplary embodiment may include a plurality of layer antennas and each layer antenna may be designed with the structure described above. In this case, each layer antenna may be connected by the method described in FIG. 9 or 10. For example, the other end 2222 of the second outer antenna segment may be electrically connected to one end of the antenna segment having an in-phase with the first inner antenna segment 2110 among the inner antenna segments of another layer through the first inter-layer capacitive element (ILC1), and the other end 2422 of the fourth outer antenna segment may also be electrically connected to one end of the antenna segment having an in-phase with the third inner antenna segment 2310 among the antenna segments of another layer through the second inter-layer capacitive element (ILC2).

As described above, the RF generator 1000, the first inner antenna segment 2110, the first outer antenna segment 2120, the first inter-turn capacitive element ITC1, the second inner antenna segment 2210, and the second outer antenna segment 2220 may constitute one closed circuit, and the RF generator 1000, the third inner antenna segment 2310, the third outer antenna segment 2320, the second inter-turn capacitive element ITC2, the fourth inner antenna segment 2410, and the fourth outer antenna segment 2420 may constitute another closed circuit.

As described in the second exemplary embodiment, since the antenna structure 2000 according to the third exemplary embodiment has two turns in one layer, and four antenna segments constitute each turn, the antenna structure 2000 and the RF generator 1000 may be connected to each other in parallel to have at least two closed circuits.

Meanwhile, unlike the second exemplary embodiment, since the antenna structure 2000 according to the third exemplary embodiment includes an inter-turn capacitive element, the magnitude of the voltage applied to each antenna segment, particularly the first to fourth antenna segments 2110, 2210, 2310, 2410 constituting the inner antenna may be lowered than that of the second exemplary embodiment. However, since the antenna structure 2000 according to the third exemplary embodiment additionally includes an inter-turn capacitive element, the design may be more complicated than in the second exemplary embodiment.

In the above, a case where the antenna structure 2000 includes at least one layer antenna but each layer antenna consists of two turns and each turn includes two to four antenna segments is mainly described. However, the technical idea of the present disclosure is not limited thereto, and one layer of the antenna structure 2000 may be composed of three or more turns, and it is possible for each turn to include five or more antenna segments.

### [New design - forth exemplary embodiment]

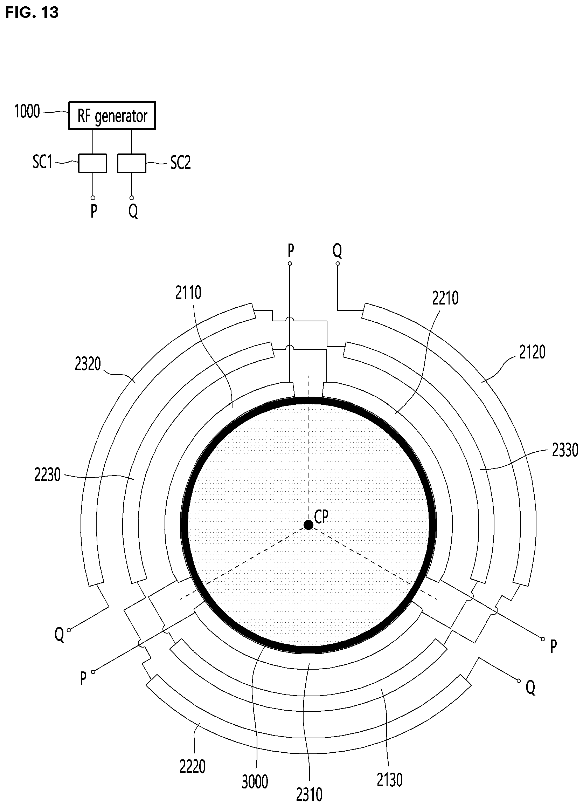

Hereinafter, another type of an antenna structure 2000 formed in the discharging tube 3000 will be described with reference to FIG. 13. Unless otherwise stated below, the content of the antenna structure 2000 according to the first exemplary embodiment described in FIGS. 6 to 9 may be applied in the same manner.

FIG. 13 is a view showing an antenna structure 2000 according to a fourth exemplary embodiment. In the antenna structure 2000 according to the fourth exemplary embodiment, antenna segments may constitute three turn antennas in each layer. Specifically, intermediate antenna segments may be disposed between the inner antenna segments and the outer antenna segments.

Referring to FIG. 13, the antenna structure 2000 may include a first inner antenna segment 2110, a second inner antenna segment 2210, a third inner antenna segment 2310, a first intermediate antenna segment 2130, a second intermediate antenna segment 2230, a third intermediate antenna segment 2330, a first outer antenna segment 2120, a second outer antenna segment 2220, and a third outer antenna segment 2320. The first to third inner antenna segments 2110, 2210, and 2310 may constitute an inner antenna, the first to third intermediate antenna segments 2130, 2230, and 2330 may constitute an intermediate antenna, and the first to third outer antenna segments 2120, 2220, and 2320 may constitute an outer antenna.

In the antenna structure 2000 according to the fourth exemplary embodiment, antenna segments may be connected to the RF generator 1000 in parallel as follows. The first inner antenna segment 2110, the first intermediate antenna segment 2130, and the first outer antenna segment 2120 may be connected in series and electrically connected to both ends of the RF generator 1000. In addition, the second inner antenna segment 2210, the second intermediate antenna segment 2230, and the third outer antenna segment 2220 may be connected in series and electrically connected to both ends of the RF generator 1000. In addition, the third inner antenna segment 2310, the third intermediate antenna segment 2330, and the third outer antenna segment 2320 may be connected in series and electrically connected to both ends of the RF generator 1000.

The antenna structure 2000 according to the fourth exemplary embodiment may be composed of a single layer or a plurality of layers.

### [The shape of the antenna structure]

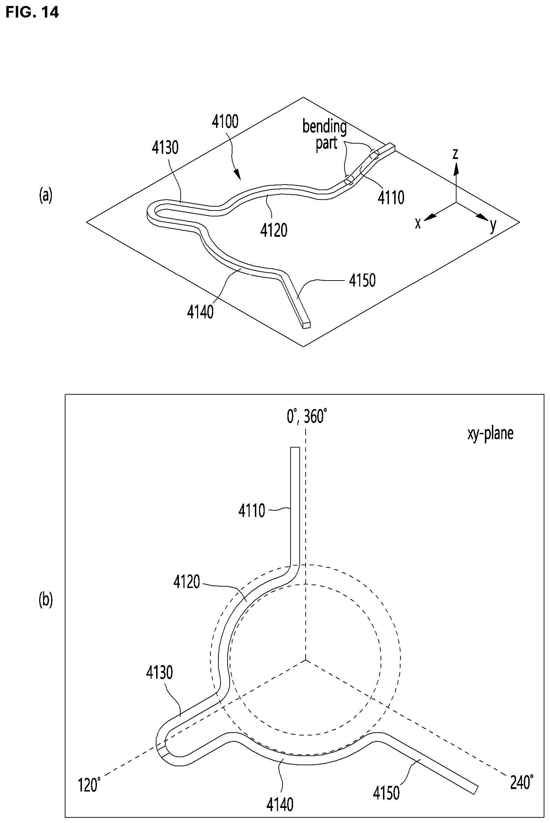

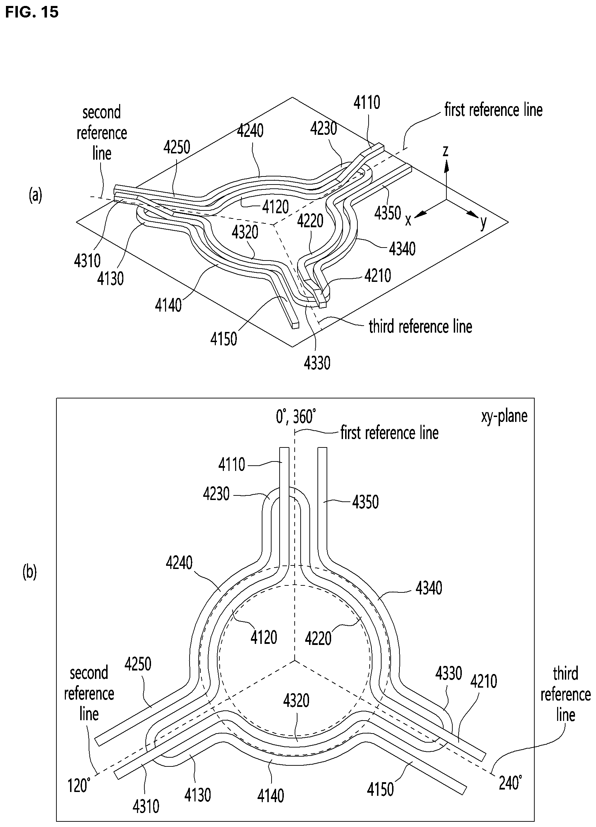

Hereinafter, a method of constructing an antenna structure 2000 using unit antennas 4100, 4200, and 4300 is described with reference to FIGS. 14 and 15. The following description assumes that the antenna structure 2000 is composed of two turns and each turn has a shape that includes three antenna segments as shown in FIG. 6.

FIG. 14 is views showing a unit antenna according to an exemplary embodiment.

Referring to FIGS. 14, a first unit antenna 4100 may include a first connecting section 4110, a first arc section 4120, a first arc connecting section 4130, a second arc section 4140 and a second connecting section 4150.

The first unit antenna 4100 may be implemented in a way of integrating the components described above. Alternatively, the first unit antenna 4100 may be constructed by assembling the above-described components, including an interconnection member.

As shown in FIG. 14, the first connecting section 4110, the first arc section 4120, the first arc connecting section 4130, the second arc section 4140, and the second connecting section 4150 may be disposed in a counter-clockwise direction. The configuration described above may be disposed in a clockwise direction.

The first connecting section 4110 may refer to a section for electrically connecting the first unit antenna 4100 to an external component. For example, the first connecting section 4110 may be electrically connected to an RF generator 1000, another unit antenna in the same layer, or any one of the unit antennas of another layer antenna.

At least a part of the first connecting section 4110 may not be located on the same plane as other components of the first unit antenna 4100. At least a part of the first connecting section 4110 may be bent. For example, referring to FIG. 14(a), when the first arc section 4120 and the first arc connecting section 4130 are located in a xy-plane in a xyz space, at least a part of the first connecting section 4110 may be bent so that one end of the first connecting section 4110 may be located on a plane while being spaced apart in a z-axis direction from a xy-plane. As described above, the first connecting section 4110 may be bent enough to prevent collision with another unit antenna (e.g., an arc connecting section of another unit antenna) in the same layer. Meanwhile, the first connecting section 4110 may not include the bent portion, may be located on the xy-plane, and may have a shape of another unit antenna bending.

The first arc section 4120 may refer to a portion surrounding at least a part of the discharging tube 3000 and forming an electric field or magnetic field inside the discharging tube 3000 by receiving voltage or electrical current.

The first arc section 4120 may be understood as a portion corresponding to the first inner antenna segment 2110 shown in FIG. 6, and the contents related to the first inner antenna segment 2110 may be applied as it is.

Specifically, the first arc section 4120 may have a first radius of curvature, and the first radius of curvature may be designed based on an outer diameter of the discharging tube 3000.

In addition, the central angle of the first arc section 4120 may be designed to be 120° or less and/or 90° or more.

The first arc connecting section 4130 may refer to a portion to which the first arc section 4120 and the second arc section 4140 are connected to each other. The first arc connecting section 4130 may be understood as a configuration corresponding to the first connecting section described in FIG. 7.

The first arc connecting section 4130 may be implemented in a U shape. However, the shape of the first arc connecting section 4130 is not limited thereto, and any shape capable of connecting the first arc section 4120 and the second arc section 4140 may be sufficient.

The first arc connecting section 4130 may be designed so as not to collide with a connecting section of another unit antenna as described later.

Like the first arc section 4120, the second arc section 4140 may have an arc shape and may mean a portion that forms an electric field or a magnetic field inside the discharging tube 3000 by receiving a voltage or an electrical current.

The second arc section 4140 is configured to form a part of the outer antenna and may have a radius of curvature greater than that of the first arc section 4120.

The second arc section 4140 may be understood as a portion corresponding to the first outer antenna segment 2120 shown in FIG. 6, and the contents related to the first outer antenna segment 2120 may be applied as it is.

Specifically, the second arc section 4140 may have a second radius of curvature, and the second radius of curvature may be designed in consideration of the first radius of curvature. For example, the second radius of curvature may be set to be larger than the first radius of curvature by a preset size. Alternatively, the second radius of curvature may be designed to be spaced apart as much as a preset distance from the fifth arc section 4320 of the third unit antenna 4300 to be described later.

In addition, the central angle of the second arc section 4140 may be designed to be 120° or less and/or 90° or more.

The second connecting section 4150 may refer to a portion for electrically connecting the first unit antenna 4100 to an external component. For example, the second connecting section 4150 may be electrically connected to an RF generator 1000, another unit antenna in the same layer, or any unit antenna of another layer antenna.

The second connecting section 4150 may be located on the same plane as the first arc section 4120 and the second arc section 4140.

Alternatively, the second connecting section 4150 may include a bent shape like the first connecting section 4110 described above.

In this case, at least one of the first connecting section 4110 and the second connecting section 4150 may include a bent shape. This is for preventing the first connecting section 4110 and the second connecting section 4150 from colliding with the arc connecting section of another unit antenna, as described later.

FIG. 15is views showing an antenna structure 2000 composed of unit antennas according to an exemplary embodiment.

Referring to FIG. 15, the antenna structure 2000 may include a first unit antenna 4100 including a first connecting section 4110, a first arc section 4120, a first arc connecting section 4130, a second arc section 4140, and a second connecting section 4150, a second unit antenna 4200 including a third connecting section 4210, a third arc section 4220, a second arc connecting section 4230, a fourth arc section 4240, and a forth connecting section 4250, and a third unit antenna 4300 including a fifth connecting section 4310, a fifth arc section 4320, a third arc connecting section 4330, a sixth arc section 4340, and a sixth connecting section 4350.

As shown in FIG. 15, the first to third unit antennas 4100, 4200, and 4300 may have substantially the same shape. Therefore, each configuration of the second and third unit antennas 4200, and 4300 may correspond to each configuration of the first unit antenna 4100 so the overlapped contents may be omitted.

The first to third unit antennas 4100, 4200, and 4300 may be disposed such that arc sections of each unit antenna may form an inner turn or an outer turn. For example, as shown in FIG. 15, the first arc section 4120 of the first unit antenna 4100, the third arc section 4220 of the second unit antenna 4200, and the fifth arc section 4320 of the third unit antenna 4300 may constitute an inner turn, and the second arc section 4140 of the first unit antenna 4100, the fourth arc section 4240 of the second unit antenna 4200, and the sixth arc section 4340 of the third unit antenna 4300 may constitute an outer turn.

The first to third unit antennas 4100, 4200, and 4300 may be disposed to be rotated as much as a preset angle. For example, the second unit antenna 4200 may be disposed to be rotated as much as about 120° from the first unit antenna 4100, and the third unit antenna 4300 may be disposed to be rotated as much as about 120° from the second unit antenna 4200.

In this case, specified may be an angle that each arc connecting section of adjacent unit antennas to each other among the first to third unit antennas 4100, 4200, and 4300 may form with respect to the center of the antenna structure 2000 or the central point of the discharging tube 3000.

Here, the unit antennas being adjacent to each other may mean that each arc connecting section of two unit antennas is close together in a clockwise or counter-clockwise direction. Alternatively, the unit antennas being adjacent to each other may mean that the arc sections constituting an inner turn in each unit antenna are adjacent to each other, or the arc sections constituting an outer turn in each unit antenna are adjacent to each other.

For example, in FIG. 15, the first unit antenna 4100 may be considered adjacent to both the second unit antenna 4200 and the third unit antenna 4300, and in this case, an angle formed by a virtual line connecting the first arc connecting section 4130 of the first unit antenna 4100 and the center of the discharging tube 3000 and a virtual line connecting the second arc connecting section 4230 of the second unit antenna 4200 or the third arc connecting section 4330 of the third unit antenna 4300 may be about 120°.

Furthermore, when the antenna structure 2000 is composed of a plurality of unit antennas, for example, a first to a-th unit antenna (a is a natural number of 2 or more), an angle formed by a first virtual line connecting the arc connecting section of the b-th unit antenna and the center of the discharging tube 3000 to each other and a second virtual line connecting the arc connecting section of (b+1)-th antenna and the center of the discharging tube 3000 may be about 360/a° in the b-th unit antenna and the (b+1)-th unit antenna adjacent to each other (b is a natural number less than a).

When the first to third unit antennas 4100, 4200, and 4300 are rotated and disposed as described above, the shape of each unit antenna may be designed such that there is no collision between the unit antennas. Here, as shown in FIG. 15, it is assumed that the first to third unit antennas 4100, 4200, and 4300 are disposed on the basis of the first to third reference lines that divide the xy-plane into three. Although the description focuses on the first unit antenna 4100 for convenience of explanation, it should be noted in advance that the same may be applied to the second unit antenna 4200 and the third unit antenna 4300.

For example, the first to third unit antennas 4100, 4200, and 4300 may be designed so that the connecting section of one unit antenna may not collide with the arc connecting section of another unit antenna. Specifically, any one of the first connecting section 4110 of the first unit antenna 4100 and the second arc connecting section 4230 of the second unit antenna 4200 may include a bent portion so that the first connecting section 4110 of the first unit antenna 4100 and the second arc connecting section 4230 of the second unit antenna 4200 may not collide with each other. More specifically, as shown in FIG. 15(a), the second arc connecting section 4230 may be positioned on a xy-plane, and at least a part of the first connecting section 4110 may be designed to be bent. Conversely, the first connecting section 4110 may be positioned on a xy-plane, and the second arc connecting section 4230 may be designed to be bent. In addition, the first connecting section 4110 of the first unit antenna 4100 may be designed to be spaced apart as much as a preset distance from the first reference line so that the first connecting section 4110 of the first unit antenna 4100 and the second arc connecting section 4230 of the second unit antenna 4200 may not collide with each other in the xy-plane.

As another example, the first arc connecting section 4130 of the first unit antenna 4100 and the sixth connecting section 4250 of the third unit antenna 4300 may be designed not to collide with each other. Specifically, referring to FIG. 15(b), the sixth connecting section 4250 may be designed to be spaced apart as much as a preset distance from the second reference line so as not to collide with the first arc connecting section 4130.

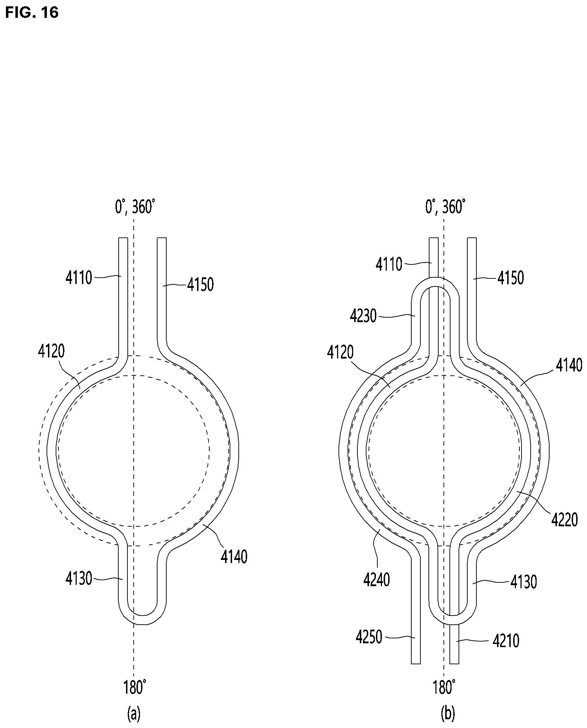

In the following, another method of configuring an antenna structure 2000 using two unit antennas will be described with reference to FIG. 16. Hereinafter, it is assumed that the antenna structure 2000 is composed of two turns and each turn has a shape that includes two antenna segments as shown in FIG. 11. Accordingly, the contents described in FIG. 11 may be applied as it is with respect to the connection relationship among antenna segments.

FIG. 16 is views showing a unit antenna (FIG. 16(a)) and an antenna structure 2000 (FIG. 16(b)) composed of unit antennas 4100 and 4200 according to an exemplary embodiment.

Referring to FIG. 16(a), the first unit antenna 4100 may include a first connecting section 4110, a first arc section 4120, a first arc connecting section 4130, a second arc section 4140 and a second connecting section 4150.

It may be understood that the first unit antenna 4100 shown in FIG. 16(a) has the same components and roles of each component as the first unit antenna 4100 shown in FIG. 14, but each shape of the components is different.

Specifically, in FIG. 16(a), the central angles of the first and second arc sections 4120 and 4140 may be designed to be 180° or less and/or 120° or more.

Referring to FIG. 16(b), the antenna structure 2000 may be composed of a first unit antenna 4100 including a first connecting section 4110, a first arc section 4120, a first arc connecting section 4130, a second arc section 4140 and a second connecting section 4150, and a second unit antenna 4200 including a third connecting section 4220, a third arc section 4220, a second arc connecting section 4230, a fourth arc section 4240, and a fourth connecting section 4250.

Referring to FIG. 16(b), the first unit antenna 4100 and the second unit antenna 4200 may not be connected in series to each other. Specifically, when the first connecting section 4110 of the first unit antenna 4100 is electrically connected to the RF generator 1000, the second connecting section 4150 of the first unit antenna 4100 may be connected to a unit antenna of another layer through a capacitive element or may be electrically connected to the RF generator 1000. Likewise, the third connecting section 4250 of the second unit antenna 4200 may be connected to a unit antenna of another layer through a capacitive element or may be electrically connected to the RF generator 1000.

The first unit antenna 4100 and the second unit antenna 4200 may be connected to the RF generator 1000 in parallel. Alternatively, the first unit antenna 4100 and the second unit antenna 4200 may be connected to different RF generators 1000.

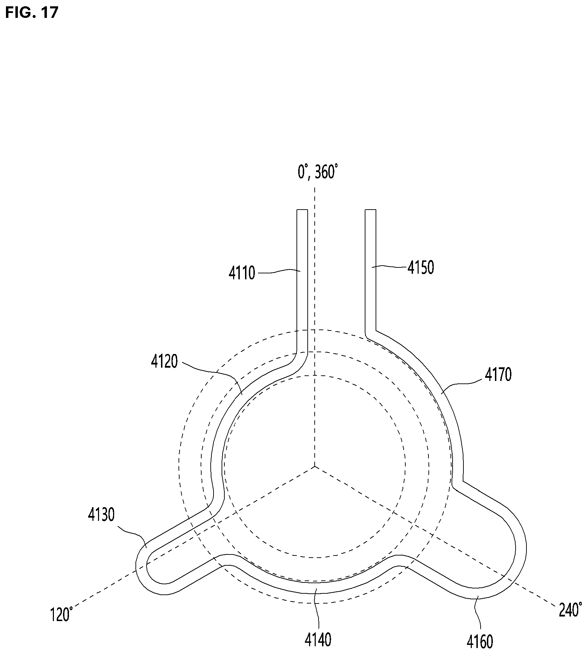

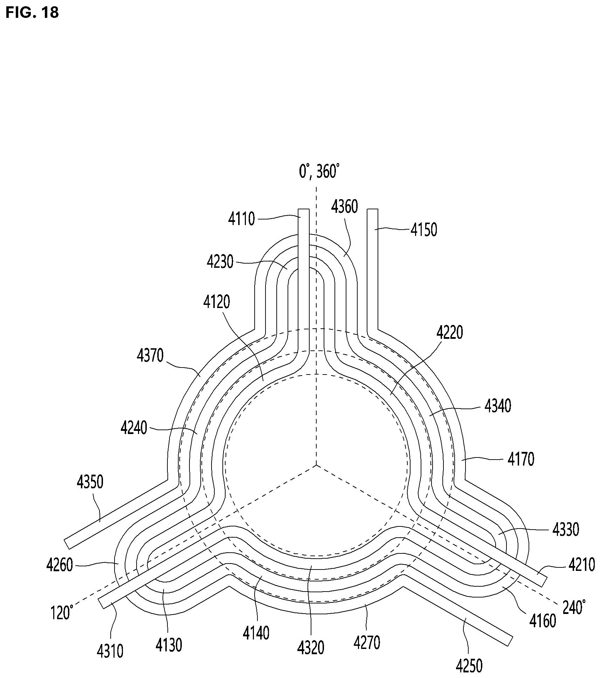

In the following, referring to FIGS. 17 and 18, another method of constructing an antenna structure 2000 having 3 turns using three unit antennas is described. Hereinafter, it is assumed that the antenna structure 2000 is composed of three turns and each turn has a shape that includes three antenna segments as shown in FIG. 13. Accordingly, the contents described in FIG. 13 may be applied as it is with respect to the connection relationship between antenna segments.

FIG. 17 is a view showing a unit antenna according to an exemplary embodiment, and FIG. 18 is a view showing an antenna structure 2000 composed of unit antennas according to an exemplary embodiment.

It may be understood that the first unit antenna 4100 shown in FIG. 17 further includes a first additional arc section 4170 and a first additional arc connecting section 4160 in the first unit antenna 4100 shown in FIG. 14. Therefore, the connection relationship among sections of the unit antenna may be changed although the contents described in FIG. 14 may be applied.

Specifically, the first unit antenna 4100 may include a first connecting section 4110, a first arc section 4120, a first arc connecting section 4130, a second arc section 4140, a first additional arc connecting section 4160, a first additional arc section 4170, and a second connecting section 41150.

The first arc section 4120 may constitute a part of the inner antenna, the second arc section 4140 may constitute a part of the intermediate antenna, and the first additional arc section 4170 may constitute a part of the outer antenna. In other words, the first additional arc section 4170 may have a third radius of curvature greater than a first radius of curvature of the first arc section 4120 or the second radius of curvature of the second arc section 4140.

Also, the second arc section 4140 may be connected to the first arc connecting section 4130 and the first additional arc connecting section 4160 unlike shown in FIG. 14. In addition, the second connecting section 4150 may be connected to the first additional arc section 4170 unlike shown in FIG. 14.

Referring to FIG. 18, the antenna structure 2000 may be composed of three unit antennas. In this case, the description of the first unit antenna 4100 described in FIG. 17 may be applied to each unit antenna as it is. In addition, the contents described in FIG. 13 may be applied to the connection relationship among unit antennas in FIG. 18.

### [Capacitor module]

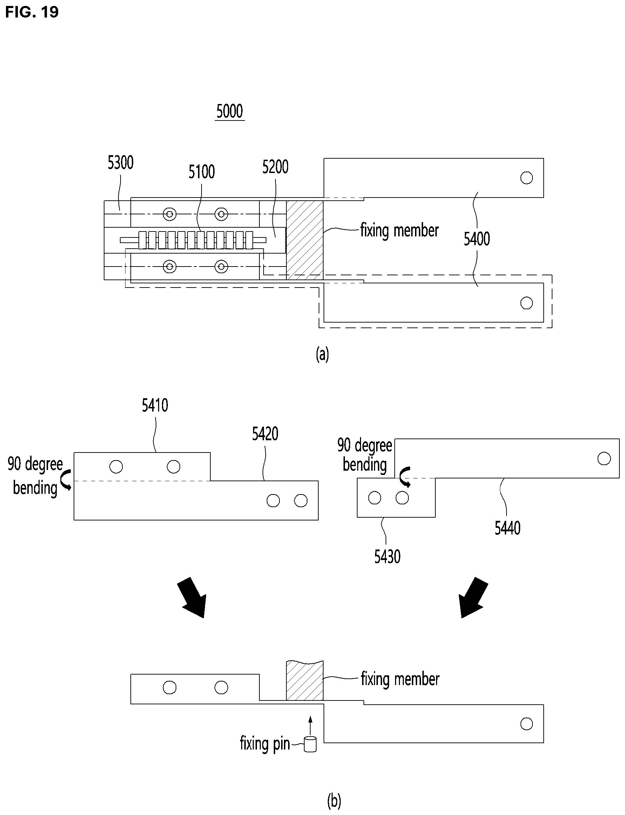

In the following, a capacitor module 5000 that serves as a capacitive element will be described, and furthermore, a method in which the capacitor module 5000 is connected to unit antennas will be described referring to FIGS. 19 to 20.

FIG. 19 is views showing a capacitor module 5000 according to an exemplary embodiment.

Referring to FIG. 19, a capacitor module 5000 may include at least one capacitor group 5100, a body 5200, a heat dissipation portion 5300, and a bus bar 5400.

The capacitor module 5000 is intended to serve as the inter-turn capacitor or inter-layer capacitor described above and may be understood as a means for a voltage rise or a voltage drop by being disposed between antenna segments in the antenna structure 2000.

The capacitor module 5000 may be implemented in a form in which at least one capacitor group 5100 is mounted on the body 5200, and a heat dissipation portion 5300 and a bus bar 5400 are assembled.

The capacitor group 5100 may include at least one capacitor, and the capacitor may be an element that accumulates electrical energy, and various types of capacitors (e.g., electrolytic capacitors, tantalum capacitors, high dielectric capacitors, Mylar capacitors, ceramic capacitors, multilayer ceramic capacitors, etc.) may be used.

The body 5200 may include a substrate on which the capacitor group 5100 is mounted.

The body 5200 may be designed to have a structure in which the heat dissipation portion 5300 and the bus bar 5400 are coupled.

The heat dissipation portion 5300 may dissipate the heat generated in the capacitor module 5000 to the outside. The heat dissipation portion 5300 may include a plurality of heat dissipation fins.

The bus bar 5400 may be used as a member for electrically connecting the capacitor module 5000 and unit antennas of the antenna structure 2000 to each other.

Meanwhile, the capacitor group 5100 of the capacitor module 5000 should be electrically interposed between the unit antennas, and the size of the capacitor group 5100 may not be small enough to be physically located between the unit antennas. Therefore, the capacitor group 5100 should be located and spaced apart as much as a certain distance from the unit antennas, and the bus bar 5400 may need to have the following shape so that the capacitor group 5100 and the unit antenna 4000 are electrically connected to each other.

Referring to FIG. 19(b), the bus bar 5400 may be divided into a first section 5410, a second section 5420, a third section 5430, and a fourth section 5440.

The first section 5410 may mean a section of the bus bar 5400 connected to the capacitor group 5100. The first section 5410 may include a first fixing hole to be fixed to the capacitor group 5100 and may be coupled to the body 5200 through a first fixing hole and a first fixing pin (or a first fixing screw).

The fourth section 5440 may mean a section of the bus bar 5400 connected to the unit antenna 4000. The fourth section 5440 may include a second fixing hole to be fixed to the unit antenna 4000 and may be coupled to any one of the unit antennas through a second fixing hole and a second fixing pin (or second fixing screw).

The second section 5420 and the third section 5430 may be understood as sections for connecting the first section 5410 and the fourth section 5440. For example, the second section 5420 may extend from the first section 5410, the third section 5430 may extend from the fourth section 5440 and the second section 5420 and the third section 5430 may be coupled so that the capacitor group 5100 may be electrically connected to the unit antenna 4000 through the bus bar 5400.

The first section 5410 and the second section 5420 may be integrally formed as one body. The second section 5420 may be bent from the first section 5410 so that an angle between the first section 5410 and the second section 5420 becomes a preset angle (e.g., 90°). Here, the preset angle may be changed as necessary.

The third section 5430 and the fourth section 5440 may be integrally formed as one body. The fourth section 5440 may be bent from the third section 5430 so that an angle between the third section 5430 and the fourth section 5440 becomes a preset angle (e.g., 90°). Here, the preset angle may be changed as necessary.

Each of the second section 5420 and the third section 5430 may include a fixing hole and may be coupled through a fixing pin (or a fixing screw). Here, a separate fixing member may be used, and the fixing member may be used as a means for supporting the capacitor module 5000.

### [Coupled with the capacitor module and unit antenna]

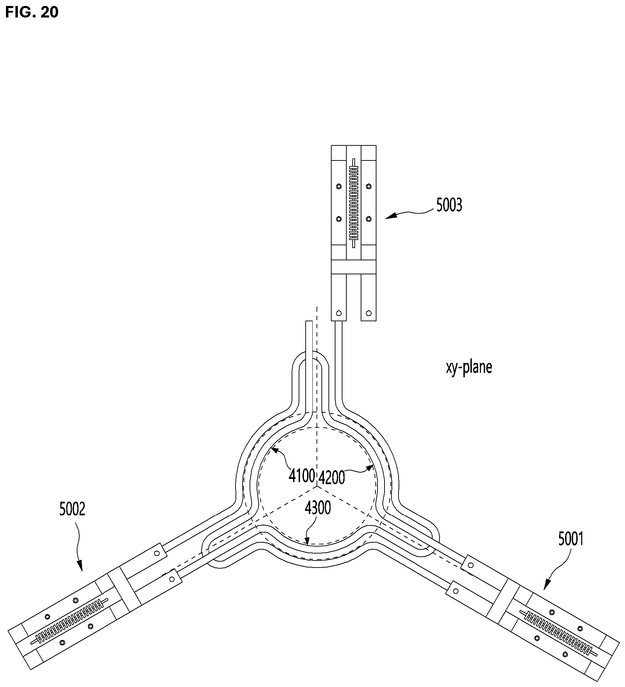

FIG. 20 is a view showing capacitor modules interposed between unit antennas according to an exemplary embodiment.

Referring to FIG. 20, an antenna structure 2000 may include a first to third unit antennas 4100, 4200, and 4300, and may further include a first to third capacitor modules 5001, 5002, and 5003.

The first capacitor module 5001 may be electrically interposed between the first unit antenna 4100 and the second unit antenna 4200. Specifically, a first bus bar of the first capacitor module 5001 may be connected to the second connecting section 4150 of the first unit antenna 4100, and the second bus bar of the first capacitor module 5001 may be connected to the third connecting section 4210 of the second unit antenna 4200.

The second capacitor module 5002 may be electrically interposed between the second unit antenna 4200 and the third unit antenna 4300. Specifically, a first bus bar of the second capacitor module 5002 may be connected to the fourth connecting section 4250 of the second unit antenna 4200, and the second bus bar of the second capacitor module 5002 may be connected to the fifth connecting section 4310 of the third unit antenna 4300.

The third capacitor module 5003 may be electrically interposed between the third unit antenna 4300 and a unit antenna of another layer. Specifically, a first bus bar of the third capacitor module 5003 may be connected to the sixth connecting section 4350 of the third unit antenna 4300, and a second bus bar of the third capacitor module 5003 may be connected to the connecting section of a unit antenna of another layer.

Meanwhile, when the antenna structure 2000 is formed as one layer, the third capacitor module 5003 may be omitted.

### [Gas reforming system]

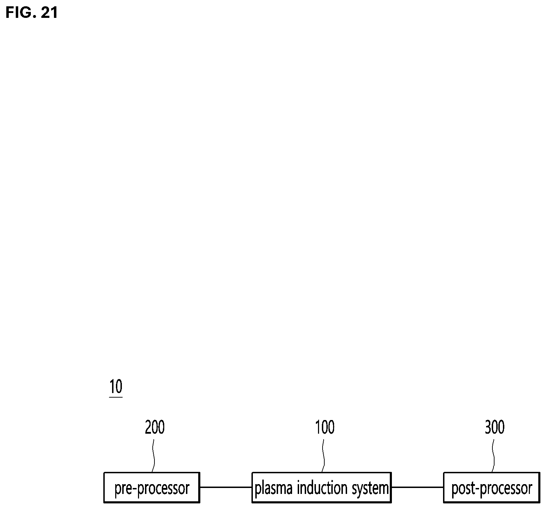

In the following, a gas reforming system 10 using a plasma induction system 100 will be described with reference to FIG. 21.

FIG. 21 is a block diagram of a gas reforming system 10 according to an exemplary embodiment. Referring to FIG. 21, the gas reforming system 10 may include a pre-processor 200, a plasma induction system 100, and a post-processor 300.

Meanwhile, although not shown in FIG. 21, the gas reforming system 10 may further include a central controller for controlling the pre-processor 200, the plasma induction system 100, and the post-processor 300. The central controller may control a first controller for controlling the pre-processor 200, a second controller for controlling the plasma induction system 100, and a third controller for controlling the post-processor 300.

Gas reforming may mean converting existing gas into another type of gas, and may be performed in various ways such as a catalyst-based reforming, a thermal energy-based reforming, and a plasma-based reforming. Gas reforming described in the present disclosure is described as a process of converting a supplied gas into another type of gas using plasma, but the technical idea of the present disclosure is not limited thereto.

The feed gas that is subject to reforming may mean the gas that is to be processed where the gas reforming system 10 is required. Alternatively, the feed gas may refer to a certain amount of gas collected by a specific method.

The feed gas may be classified into biogas, landfill gas (LFG), natural gas, or methane gas depending on the cause of the generation. Depending on the type, the gas to be reformed may include methane (CH₄), carbon dioxide (CO₂), hydrogen (H₂), oxygen (O₂), nitrogen (N₂), and the like. Hereinafter, for convenience of explanation, a case where the feed gas includes at least methane and carbon dioxide will be described, but the technical idea of the present disclosure is not limited thereto.

When the feed gas is reformed, synthesis gas may be generated. Synthetic gas may be a mixed gas of hydrogen and carbon monoxide and may be not only a raw material for various chemical products but also an energy source such as electricity generation. More specifically, the final product that is ultimately produced may vary depending on what post-process is performed on the synthesis gas.

In the present disclosure, the final product to be obtained through the gas reforming system 10 may mean high-purity hydrogen, methanol, aviation oil, base oil, bio-naphtha, biodiesel, carbon black, graphene, carbon nanotube, ammonia, or carbon monoxide, but is not limited thereto.

The gas reforming system 10 described in the present disclosure may perform a pre-process, a reforming process, and a post-process, and each process may be carried out in a pre-processor 200, a plasma induction system 100, and a post-processor 300 respectively. The configurations mentioned and each process will be described below.

First, a pre-process on the feed gas may be performed by the pre-processor 200 before gas reforming.

The pre-process is a process for performing gas reforming more efficiently and may be performed in consideration of the production amount of synthesis gas produced by gas reforming, the composition ratio of synthesis gas, energy conversion efficiency, and the like.

For example, a desulfurization process and a gas separation process may be performed on the feed gas in the pre-processor 200.

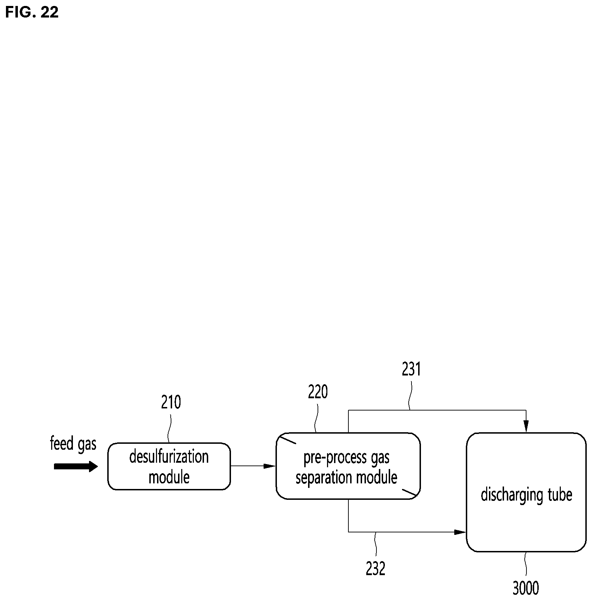

In the following, the structure and function of the pre-processor 200 will be described with reference to FIG. 22.

FIG. 22 is a block diagram of the pre-processor 200 according to an exemplary embodiment. Referring to FIG. 22, the pre-processor 200 may include a desulfurization module 210, a preprocess gas separation module 220, a first gas separation tube 231, and a second gas separation tube 232.

The desulfurization module 210 may perform a desulfurization process on the feed gas. The desulfurization process may be understood as one of the processes of filtering out unnecessary components before injecting the feed gas into the discharging tube 3000 of the plasma induction system 100.

Specifically, when the feed gas is biogas, components such as hydrogen sulfide, halide, and silicon-containing compounds may be included. These components may need to be removed from the feed gas because they may form corrosive acids during the reforming process and damage the durability of the discharging tube 3000 or the post-processor 300.

The desulfurization module 210 may be supplied with a feed gas and remove hydrogen sulfide. The process of removing hydrogen sulfide in desulfurization module 210 may be classified into a dry, a wet, and a biological process. For example, the desulfurization module 210 may perform a dry desulfurization process that removes hydrogen sulfide with physical/chemical adsorption using metal oxides such as iron, zinc, and copper and with adsorbents such as activated carbon. For another example, the desulfurization module 210 may perform a wet desulfurization process in which hydrogen sulfide is dissolved by contacting the feed gas with liquid at a specific temperature and a specific pressure. For another example, the desulfurization module 210 may perform a biological desulfurization process that oxidizes and decomposes hydrogen sulfide and removes it using microbial metabolism.

The desulfurization module 210 may be fluidly connected to the pre-process gas separation module 220. Specifically, an outlet of the desulfurization module 210 may be fluidly connected to an inlet of the pre-process gas separation module 220, so that the gas passing through the desulfurization process in the desulfurization module 210 may be transferred into the preprocess gas separation module 220.

The pre-processor 200 may further include a module for removing a specific component in addition to the desulfurization module 210. For example, the pre-processor 200 may further include a dehumidification module for removing moisture when the feed gas is the landfill gas.

The pre-process gas separation module 220 may separate the supplied gas into a plurality of sub-feed streams. For example, the pre-process gas separation module 220 may separate the supplied feed stream into a first sub-feed stream and a second sub-feed stream.

The pre-process gas separation module 220 may be connected to a plurality of gas separation tubes. For example, an outlet of the pre-process gas separation module 220 may be connected to a first gas separation tube 231 and a second gas separation tube 232. The first sub-feed stream separated by the pre-process gas separation module 220 may be transferred to the first gas separation tube 231, and the second sub-feed stream may be transferred to the second gas separation tube 232.

A plurality of gas separation tubes may be understood as a configuration that fluidly connects the pre-process gas separation module 220 and the discharging tube 3000. Here, a plurality of gas separation tubes may perform a function of supplying the gas having a specific composition ratio to a specific location of the discharging tube 3000. For example, as described later, the first gas separation tube 231 may be connected to an inlet located at the top of the discharging tube 3000 so that CO₂-rich gas is supplied to the top of the plasma induction region of the discharging tube 3000. In addition, as described later, the second gas separation tube 232 may be connected to the second inlet located at the bottom of the discharging tube 3000 so that methane-rich gas (CH₄-rich gas) is supplied to the bottom of the plasma induction area of the discharging tube 3000.

When separating gas from the pre-process gas separation module 220, a separation membrane including a porous structure may be used. For example, the pre-process gas separation module 220 may contain a membrane that includes pores having a size within a certain range within its interior.

The separation membrane may be disposed between the inlet of the pre-process gas separation module 220 and the first gas separation tube 231. Alternatively, the separation membrane may be disposed between the inlet of the pre-process gas separation module 220 and the second gas separation tube 232.

The separation membrane may separate gases having particles of a certain size among gases of the feed stream supplied to the pre-process gas separation module 220. For example, when a feed stream is supplied into the pre-process gas separation module 220, hydraulic pressure is formed, and some of the feed streams may pass through the separation membrane by the formed hydraulic pressure.

In the present disclosure, the pre-process gas separation module 220 may aim to separate the supplied feed stream into a first sub-feed stream with a high molar ratio of carbon dioxide and a second sub-feed stream with a high molar ratio of methane. For example, the molar ratio of carbon dioxide to methane in the first sub-feed stream may be about 10:0 to 7:3, and the molar ratio of carbon dioxide to methane in the second sub-feed stream may be about 0:10 to 2:8.

A molar ratio of carbon dioxide in the first sub-feed stream may be greater than a molar ratio of carbon dioxide in the second sub-feed stream. In addition, the molar ratio of methane in the first sub-feed stream may be smaller than the molar ratio of methane in the second sub-feed stream.

Meanwhile, the molar ratio of carbon dioxide in the first sub-feed stream and the molar ratio of methane in the second sub-feed stream may vary depending on the design method of the preprocess gas separation module 220. For example, the molar ratio of carbon dioxide in the first sub-feed stream and the molar ratio of methane in the second sub-feed stream may be determined according to the pressure in the pre-process gas separation module 220 and the pore size of the separation membrane.

The reason for separating the gas in this way may be that: i) it is necessary to inject gases involved in endothermic reactions, such as methane, into the rear end of the plasma induction region in order to maintain plasma discharge; and ii) the composition ratio of the gas flowing into the discharging tube 3000 should be controlled to be within a certain range so that the ratio of hydrogen and carbon monoxide in the reformed synthesis gas through the plasma induction system 100 may become a specific value as described later. Considering this, a specification of a separation membrane may need to be appropriately selected in order to separate the feed stream supplied from the pre-process gas separation module 220 into a plurality of sub-feed streams having a preferable ratio of gas composition.

For example, when the ratio of carbon dioxide is about 34%, the ratio of methane is about 44%, the ratio of nitrogen is about 20%, and the ratio of oxygen is about 2% in the feed stream being supplied to the pre-process gas separation module 220, the ratio of carbon dioxide is about 60%, the ratio of methane is about 25%, the ratio of nitrogen is about 12%, the ratio of oxygen is about 3% in the first sub-feed stream, and the ratio of carbon dioxide is about 10%, the ratio of methane is about 58%, the ratio of nitrogen is about 29%, and the ratio of oxygen is about 3% in the second sub-feed stream.

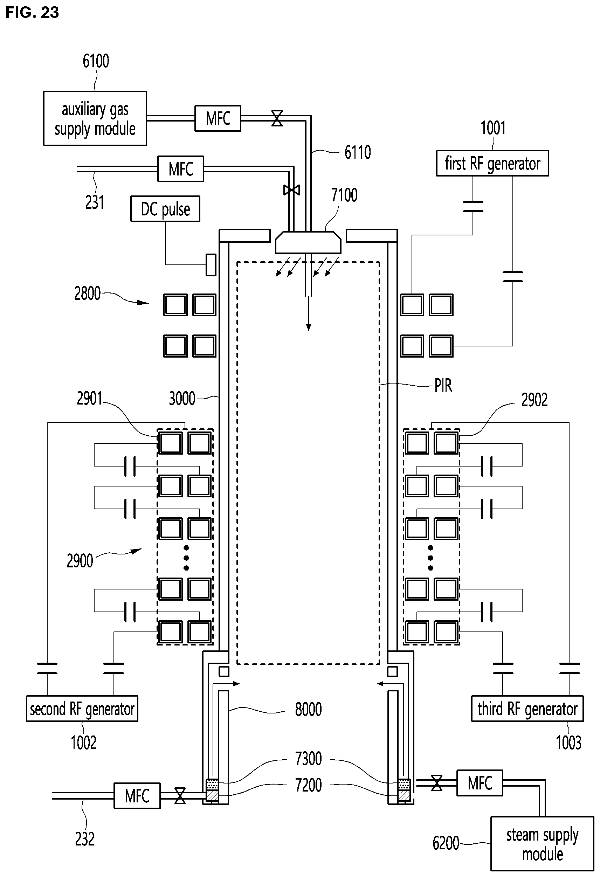

Hereinafter, a plasma induction system 100 for gas reforming will be described with reference to FIG. 23.

FIG. 23 is a view showing a plasma induction system 100 for gas reforming according to an exemplary embodiment.

The plasma induction system 100 may be understood as a system that reforms the gas supplied from the pre-processor 200 using plasma in order to produce synthesis gas and then to supply the produced synthesis gas to the post-processor 300.

The plasma induction system 100 may perform gas reforming by generating plasma through plasma induction, by receiving the preprocessed feed gas and by passing it through the plasma region.

For example, when reforming feed gas containing methane and carbon dioxide, the following reactions may proceed in the discharging tube 3000.

CH₄ + H₂O → CO + 3H₂

CO + H₂O → CO₂ + H₂

CH₄ + CO₂ → 2CO + 2H₂

The above reactions may be carried out in the process of decomposing and re-synthesizing gases supplied by the thermal energy of plasma, and as a result, synthesis gas containing hydrogen and carbon monoxide may be produced by reforming methane and carbon dioxide of the feed gas by plasma.

Referring to FIG. 23, the plasma induction system 100 may include an RF generator 1000, an ignition antenna structure 2800, a main antenna structure 2900, a discharging tube 3000, an auxiliary gas supply module 4100, a steam supply module 6200, an upper swirl generator 7100, lower swirl generators 7200 and 7300, and a guide structure 8000.

First, the antenna structure 2000 may be divided into an ignition antenna structure 2800 and a main antenna structure 2900.

The ignition antenna structure 2800 is configured to induce plasma generation and may be disposed to surround the outer surface of the discharging tube 3000. The ignition antenna structure 2800 may have a layered structure, and for example, as shown in FIGS. 3 and 23, it may have a 2-layer-2-turn structure that includes two layer antennas in which each layer antenna composed of two turns. However, the number of layers and the number of turns per layer of the ignition antenna structure 2800 may not be limited to 2-layer-2-turn and may be determined appropriately as necessary.

Unlike the main antenna structure 2900, a capacitive element may be not disposed among the layer antennas in the ignition antenna structure 2800. That is, it is necessary that a high voltage is applied to the ignition antenna structure 2800 as described above and thereby it should be avoided for the magnitude of the voltage to be decreased as a capacitive element is disposed between the layer antennas (or unit antennas).

The ignition antenna structure 2800 may induce plasma by forming a relatively strong electric field in the discharging tube 3000 compared to the main antenna structure 2900 and then causing particles to collide with each other at high speed.

The main antenna structure 2900 may be configured to maintain plasma and may be disposed to surround the outer surface of the discharging tube 3000. The main antenna structure 2900 may be disposed and spaced apart as much as a certain distance from the ignition antenna structure 2800 in a parallel direction to the central axis of the discharging tube 3000.

The main antenna structure 2900 may be understood to have any one of the shapes of the antenna structure 1000 described in FIGS. 7 to 18. Hereinafter, for convenience of explanation the main antenna structure 2900 may have the shape described in FIGS. 11, 16 and include a first main antenna module 2901 and a second main antenna module 2902 connected to different RF generators, but the technical idea of the present disclosure is not limited thereto.

The plasma induction region (PIR) in the discharging tube 3000 may be defined by the ignition antenna structure 2800 and the main antenna structure 2900. When electric power is applied to the ignition antenna structure 2800 with the injection of auxiliary gas, plasma may be ignited in a region corresponding to the ignition antenna structure 2800 in the plasma induction region (PIR), and then, when electric power is applied to the main antenna structure 2900, the plasma may be transferred to and maintained in a region corresponding to the main antenna structure 2900 in the plasma induction region (PIR), and while plasma is maintained the gas to be reformed may be injected into the inside of the discharging tube 3000 and gas reforming may be performed.

The RF generator 1000 may be a means of applying electric power to the antenna structure 2000, and the structure and the method of applying electric power will be omitted as has been described above.

The number of RF generators 1000 may vary depending on the structure of the main antenna structure 2900.

For example, when the main antenna structure 2900 may be composed of unit antennas in which layer antennas are not connected in series to each other as described in FIGS. 11 and 16, and unit antennas of each layer may be connected in series to unit antennas of other layers, the main antenna structure 2900 may be composed of a first main antenna module 2901 and a second main antenna module 2902 which are not connected to each other by conductors. In this case, the RF generator 1000 may be divided into a first RF generator 1001 for applying electric power to the ignition antenna structure 2800, a second RF generator 1002 for applying electric power to the first main antenna module 2901, and a third RF generator 1003 for applying electric power to the second main antenna module 2902. However, even in this case, the first main antenna module 2901 and the second main antenna module 2902 may be powered by one RF generator.

As another example, when antenna segments within a layer antenna are connected in series to each other and layer antennas are also connected in series to each other in the main antenna structure 2900 as described in FIG. 9, the RF generator 1000 may be divided into a first RF generator 1001 for applying electric power to the ignition antenna structure 2800 and a second RF generator 1002 for applying electric power to the main antenna structure 2900.

The auxiliary gas supply module 6100 may supply an auxiliary gas into the discharging tube 3000. Here, the auxiliary gas may be understood as the gas used to discharge plasma, such as argon gas or helium gas.

The auxiliary gas supply module 6100 may supply auxiliary gas to the top of the discharging tube 3000 through the auxiliary gas supply tube 6110, and the amount of the supplied auxiliary gas may be controlled by a mass flow controller (MFC).

The auxiliary gas may be transferred to the upper swirl generator 7100 through the auxiliary gas supply tube 6110 and then transferred into the discharging tube 3000 in a state of having a specific shape (e.g., a straight forward, a clockwise swirl, or a counter-clockwise swirl) in the upper swirl generator 7100.

The steam supply module 6200 may supply water vapor into the discharging tube 3000. The steam supply module 6200 may be fluidly connected to the discharging tube 3000 in order to adjust the ratio of water vapor in the gas stream supplied into the discharging tube 3000 within a preset range.

A first sub-feed stream described above may flow into the discharging tube 3000 through the upper swirl generator 7100. A second sub-feed stream may flow into the discharging tube 3000 through a first lower swirl generation 7200. The water vapor supplied from the steam supply module 6200 may flow into the discharging tube 3000 through a second lower swirl generation 7300.

In this way, the first sub-feed stream, the second sub-feed stream, and the water vapor may be supplied into the discharging tube 3000 while having a specific shape (e.g., a clockwise swirl or a counter-clockwise swirl) respectively. In this case, the swirl directions of the first sub-feed stream, the second sub-feed stream, and the water vapor may be determined in order to increase the energy conversion efficiency. A method of determining the swirl direction of each stream will be described later.

The guide structure 8000 may be a structure for supplying gas to the rear end of the plasma induction region (PIR) inside the discharging tube 3000. For example, referring to FIG. 23, the guide structure 8000 may extend from the lower end of the discharging tube 3000 to the rear end of the plasma induction region (PIR), and the gas supplied to the lower end of the discharging tube 3000 may move along the outer wall of the guide structure 8000 and reach the rear end of the plasma induction region (PIR).

The guide structure 8000 may be inserted into the discharging tube 3000. For example, the discharging tube 3000 may be divided into a first section and a second section having different widths, an ignition antenna structure 2800 and a main antenna structure 2900 may be disposed in the first section, and a guide structure 8000 may be inserted into the inner side of the second section.

Meanwhile, the plasma induction system 100 may further include an electrode attached to the outside of the discharging tube 3000 for plasma ignition along with the ignition antenna structure 2800 and a pulse generator that applies a high voltage pulse to the electrode. When a high voltage pulse is applied to the electrode, the end of the auxiliary gas supply tube 6110 located inside the discharging tube 3000 may serve as a different electrode so that a strong electric field is formed between the electrode and the auxiliary gas supply tube 6110 and facilitates plasma ignition.

The plasma induction system 100 may operate as follows.

First, a plasma ignition operation may be performed. Specifically, while auxiliary gas is supplied into the discharging tube 3000, electric power may be applied to the ignition antenna structure 2800 by the first RF generator 1001, and plasma in the discharging tube 3000 may be ignited.

Thereafter, the plasma maintenance operation may be performed. Specifically, electric power by the second RF generator 1002 may be applied to the first main antenna module 2901, and electric power by the third RF generator 1003 may be applied to the second main antenna module 2902, so that plasma ignited near the ignition antenna structure 2800 in the discharging tube 3000 may be transferred to and be maintained near the main antenna structure 2900.

The gas to be reformed may be supplied in a state where plasma is maintained. Specifically, a first sub-feed stream (CO₂-rich gas) may flow in from an upper end of the discharging tube 3000, and a second sub-feed stream (CH₄-rich gas) and water vapor may flow in from a rear end of the plasma induction region (PIR) in the discharging tube 3000.

As the first sub-feed stream, the second sub-feed stream and the water vapor may flow into the discharging tube 3000, the chemical reaction by plasma described above may occur, thereby generating synthesis gas.

A post-process may be performed on the synthesis gas generated in the plasma induction system 100, thereby generating a final product.

The post-process may be largely understood as a gas transition process and a gas separation process, and the post-processing portion 300 may include a gas transition module and a post-process gas separation module for each process.

First, the synthesis gas generated in the discharging tube 3000 may be transferred to the gas transition module, and hydrogen or carbon monoxide in the synthesis gas may be converted into a specific gas. At this time, the gas transition module may have a different composition or structure depending on the type of final product to be produced in the gas reforming system 10 and the type of reaction that occurs may also be different.

For example, the gas transition module may be a water gas shift (WGS) module. The water gas shift module may perform a process of converting carbon monoxide in the synthesis gas into hydrogen using a catalytic reaction. Specifically, the water gas shift module may be supplied with synthesis gas and water vapor and then generate a reaction of CO + H₂O -> CO₂ + H₂.

When the final product to be produced in the gas reforming system 10 is high-purity hydrogen, the water gas shift module may be selected as the gas transition module. Alternatively, in the process of collecting carbon dioxide through the gas reforming system 10, the water gas shift module may be selected as the gas transition module.

As another example, the gas transition module may be a Fischer-Tropsch process module. The Fisher-Tropsch process module may perform a process of synthesizing liquid hydrocarbons from the synthesis gas using a catalytic reaction. Specifically, the Fisher-Tropsch process module may be supplied with synthetic gas and generate a reaction of (2n+1)H₂ + (n)CO -> C(n)H(2n+2) + (n)H₂O.

When the final product to be produced in the gas reforming system 100 is aviation oil, the Fisher-Tropsch process module may be selected as a gas transition module.

As another example, the gas transition module may be a methanol synthesis module. The methanol synthesis module may be implemented as a fixed bed reactor or a fluidized bed reactor and may perform a process of synthesizing methanol from the synthesis gas using a catalytic reaction.

The gas discharged through the gas transition module may be supplied to the post-process gas separation module. Hereinafter, the gas discharged from the gas transition module may be referred to as an intermediate product (IP) for convenience of explanation.

The post-process gas separation module may perform a gas separation process. The gas separation process performed in the post-process gas separation module may be understood as a process that increases the efficiency of obtaining a final product.

The post-process gas separation module may be implemented as a pressure swing adsorption (PSA) method. The pressure swing adsorption method may separate gas by first adsorbing components with high selectivity using an adsorbent among passing gases and by first discharging components with low selectivity.

The post-process gas separation module may be implemented in a form including a separation membrane like the pre-process gas separation module described above.

The gas discharged from the post-process gas separation module may be a final product and may be collected in the collector. There may be an additional configuration such as changing a pressure or a temperature between the post-process gas separation module and the collector.

Meanwhile, in a process of reforming gas using the gas reforming system 10 there is a case where the use of auxiliary gas for greatly helping plasma ignition and maintenance should be avoided depending on the type of final product of the gas reforming process.

For example, when the final product of the gas reforming process is high-purity hydrogen, hydrogen may be collected from synthesis gas produced by plasma reforming through a post-process but in this case, when auxiliary gases such as argon gas are mixed with synthesis gas, it is relatively difficult to separate hydrogen and argon gas in the synthesis gas, resulting in a significantly reduced process efficiency due to a reduced production of high-purity hydrogen or the need for additional equipment.

Considering the above circumstances, even when auxiliary gas is used in the plasma ignition stage, it may be considered not to use auxiliary gas in the plasma maintenance stage where synthesis gas is actively produced.

When auxiliary gas is not used, plasma maintenance may weaken and plasma may become unstable, and in order to compensate for this, the driving frequency of the electric power applied to the main antenna structure 2900 should be increased. However, as the driving frequency increases, the maximum voltage applied to the main antenna structure 2900 may also increase such that the risk of arcing between layer antennas is increased and accordingly the risk of structure damage is increased.

In order to solve the above problems, an antenna structure where arcing may not occur without using auxiliary gas in the plasma maintenance stage has been researched and developed.

As a result, a plasma induction system 100 using an antenna structure 2000 described in the present disclosure has been constructed, a gas reforming system 10 using the constructed plasma induction system 100 has been designed, and it has been confirmed through experiments that the production amount of synthesis gas may be maintained at a certain level by maintaining plasma even when auxiliary gas is not used.

In the following, it will be described in detail using experimental data.

First of all, the designed gas reforming system 10 is previously described in FIGS. 21 to 23, so the details will be omitted. In the experiment, the production amount of synthesis gas and the energy conversion efficiency (ECE) is checked by maintaining the flow rate of methane gas in the first sub-feed stream, the flow rate of carbon dioxide gas in the second sub-feed stream, and the supply amount of the water vapor at a constant value, and by adjusting the injection amount of argon gas, and whether arcing occurs is checked in the process.

**Table 1**

| **No.** | **Setup** | **Inlet Composition** | | | | **Outlet Composition** | **ECE (%)** |
|---|---|---|---|---|---|---|---|
| | | **CH₄ (LPM)** | **CO₂ (LPM)** | **Ar (LPM)** | **H₂O (cc)** | **Syngas (LPM)** | |
| 1 | quartz disk + air gap 1 mm | 41 | 24 | 6 | 70 | 147.5 | 64.37 |
| 2 | lower nozzle direction CCW | 41 | 24 | 0 | 70 | 151.03 | 63.95 |
| 3 | air gap 3 mm | 41 | 24 | 6 | 70 | 124.01 | 67.02 |
| 4 | lower nozzle direction CCW | 41 | 24 | 0 | 70 | 140.63 | 66 |
| 5 | air gap 3 mm | 41 | 24 | 6 | 70 | 122.65 | 66.56 |
| 6 | lower nozzle direction CCW | 41 | 24 | 0 | 70 | 151.37 | 65.08 |
| 7 | quartz disk + air gap 1 mm | 41 | 24 | 6 | 70 | 140.74 | 67.11 |
| 8 | lower nozzle direction CW | 41 | 24 | 0 | 70 | 148.95 | 67.19 |
| 9 | air gap 3 mm | 41 | 24 | 6 | 70 | 133 | 69.69 |
| 10 | lower nozzle direction CW | 41 | 24 | 0 | 70 | 157.3 | 67.58 |

In each experiment shown in Table 1 above, a main antenna structure 2900 may use a form (hereinafter, a shape of 2-division) described in FIGS. 11 and 16. The quartz discs and air gap in the "Setup" may indicate the adjustment of the permittivity between the layered antennas in the main antenna structure 2900, and a method of adjusting the permittivity between the layered antennas will be described later. The lower nozzle direction in "Setup" may indicate a swirl direction of methane gas when viewed from the upper portion of the discharging tube 3000, and may be related to a swirl direction of water vapor, and a method of determining the swirl direction of methane gas will be described later. Furthermore, in all experiments, argon gas may be injected into the discharging tube 3000 during plasma ignition, and the amount of argon gas described in Table 1 may indicate the amount of argon gas that flows into the discharging tube 3000 in the plasma maintenance stage after plasma ignition is detected.

Referring to Table 1, it is confirmed that the synthesis gas production and the energy conversion efficiency are maintained above a certain level even when argon gas may not be injected in a stage where plasma is maintained by the main antenna structure 2900. Specifically, when argon gas is not injected in each Setup, the production amount of synthesis gas is increased compared to that when argon gas is injected, and the energy conversion efficiency is slightly reduced.

Meanwhile, in experiments where argon gas may not be injected, it is not confirmed that the arcing or the damage caused by arcing may occur.

In other words, as a result of experimenting with various types of Setup using a 2-division shape of a main antenna structure 2900, it is confirmed that it is possible to maintain plasma without injecting argon gas in the plasma maintenance stage and that the production amount of synthesis gas and the energy conversion efficiency exceed a certain standard.

As described above, when an auxiliary gas such as argon gas is not used in maintaining plasma, a plasma reforming method that minimizes the use of auxiliary gas may be derived.

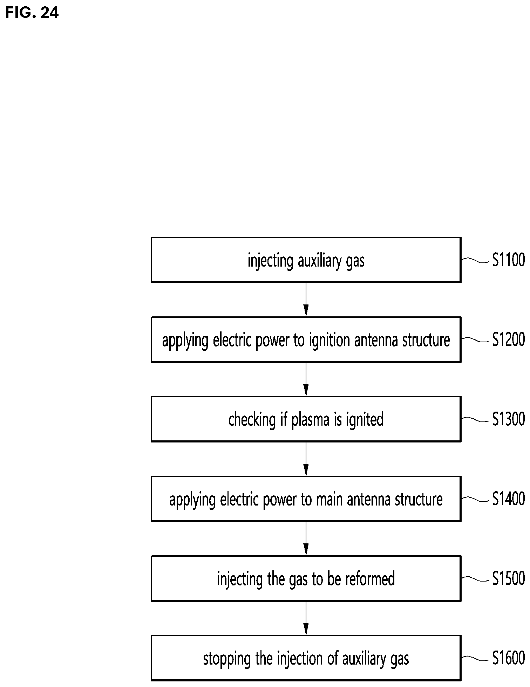

Hereinafter, a plasma reforming method that minimizes the use of auxiliary gas will be described with reference to FIG. 24.

FIG. 24 is a flowchart showing a plasma reforming method according to an exemplary embodiment.

Referring to FIG. 24, the plasma reforming method may include step S1100 of injecting an auxiliary gas, step S1200 of applying electric power to the ignition antenna structure 2800, step S1300 of checking whether plasma is ignited, step S1400 of applying electric power to the main antenna structure, step S1500 of injecting the gas to be reformed, and step S1600 of stopping the injection of auxiliary gas.

In the following, each step will be described in detail.

First, an auxiliary gas may be injected into the discharging tube 3000. This is one of the steps for plasma ignition and may be understood as an operation to create an environment favorable for igniting plasma.

Meanwhile, in order to create a more favorable environment for plasma ignition, the internal pressure of the discharging tube 3000 may be lowered. In order to lower the internal pressure, the discharging tube 3000 may be connected to a pressure pump, and the pressure pump may adjust the pressure inside the discharging tube 3000. A preferable environment for plasma ignition may be created when plasma is ignited only with the main antenna structure 2900 without using the ignition antenna structure 2800. However, even when the ignition antenna structure 2800 is used, an environment favorable for plasma ignition may be created by lowering the internal pressure. In the case when the internal pressure of the discharging tube 3000 is lowered, a step of increasing the internal pressure of the discharging tube 3000 may be additionally performed after plasma is ignited.

In addition, the plasma induction system 100 may further include an exhaust system for exhausting gas in the discharging tube 3000, and the auxiliary gas injected into the inside of the discharging tube 3000 may be exhausted through the exhaust system, it prevents the auxiliary gas from moving to the post-processor 300. More specifically, the plasma induction system 100 may further include an exhaust port and an exhaust pump that may fluidly connect the discharging tube 3000 and the exhaust system, and by operating the exhaust pump the gas in the discharging tube 3000 may be exhausted into the exhaust system. This is to prevent from acting unfavorably in producing the target gas in the post-process in case the auxiliary gas may be transferred to the post-processor 300 as described above.

After the auxiliary gas is injected, electric power may be applied to the ignition antenna structure 2800 for plasma ignition S1200. For example, an RF voltage may be applied to the ignition antenna structure 2800 through the first RF generator 1001. The ignition antenna structure 2800 receiving an RF voltage may form an electric field inside the discharging tube 3000, and the formed electric field may cause the argon gas to collide with each other, thereby igniting plasma.

The Step S1100 and the step S1200 may be performed simultaneously. Alternatively, the step S1200 may be first performed before the step S1100.

It may be confirmed whether plasma is ignited S1300. Whether plasma is ignited may be determined on the basis of the degree of variance in the electric power applied to the ignition antenna structure 2800. For example, it may be determined that plasma is ignited when the voltage or current measured with respect to the ignition antenna structure 2800 falls outside a threshold range. For another example, it may be determined that plasma is ignited when the amount of variance in voltage or current measured with respect to the ignition antenna structure 2800 falls outside a threshold range. Meanwhile, whether plasma is ignited may be automatically detected by the plasma induction system 100, or may be detected by a user's input (e.g., a user may check with the naked eye if plasma is ignited and may input the checked result to the plasma induction system 100).

When plasma ignition is detected, electric power may be applied to the main antenna structure 2900 for a main discharge S1400. For example, the second RF generator 1002 and/or the third RF generator 1003 may apply electric power to the main antenna structure 2900, and the main antenna structure 2900 may form electric and magnetic fields in the discharging tube 3000 to maintain plasma.

The main discharge may refer to a phenomenon in which plasma ignited by the ignition antenna structure 2800 moves to the main antenna structure 2900 and is maintained thereon. Specifically, when electric power is applied to the main antenna structure 2900, plasma generated in a region corresponding to the ignition antenna structure 2800 in the plasma induction region (PIR) within the discharging tube 3000 may move to a region corresponding to the main antenna structure 2900 in the plasma induction region (PIR) and plasma may be maintained while particles in the discharging tube 3000 may collide with each other by an electromagnetic field that the main antenna structure 2900 may form.

In a state where plasma is maintained, the gas to be reformed may be injected S1500. For example, carbon dioxide-rich gas, methane-rich gas, and water vapor may be injected into the discharging tube 3000.

The time when the gas to be reformed is injected may be selected from the time elapsed for a certain time from when the plasma induction system 100 is operated, the time elapsed for a certain time from when electric power is applied to the ignition antenna structure 2800, the time when plasma ignition is confirmed, the time elapsed for a certain time from when plasma ignition is confirmed, the preceding time for a certain time from when the injection of auxiliary gas is stopped, the time when the injection of auxiliary gas is stopped, and the time elapsed for a certain time from when the injection of auxiliary gas is stopped. Meanwhile, the gas to be reformed may be injected according to a user's input.

In other words, step S1500 is not necessarily performed after step S1400, and step S1500 may be performed even while step S1100 or step S1400 is performed. However, the timing of injecting the gas to be reformed should be determined in consideration of the performance and the energy conversion efficiency of the plasma induction system 100 or the gas reforming system 10 since it is possible to ignite plasma with auxiliary gas alone, and depending on the final product to be produced, it may be possible to exhaust all of the gas in the discharging tube 3000 in order to exhaust the auxiliary gas before reaching a normal state after injecting the gas to be reformed as described later and in this case the synthesis gas produced by reforming the gas to be reformed may be unnecessarily consumed.

The injection of auxiliary gas may be stopped after the gas to be reformed has been injected S1600.

A stop timing of injecting the auxiliary gas may be selected as any one of the time when plasma is ignited, the time elapsed for a certain time from when plasma is ignited, the preceding time for a certain time on the basis of the time when the gas to be reformed is injected, the time when the gas to be reformed is injected, and the time elapsed for a certain time from when the gas to be reformed is injected. In other words, step S1600 may not necessarily have to be performed after step S1500, and may be performed during step S1300 or step S1500.

Meanwhile, when plasma is maintained by the main discharge and reaches a normal state, the plasma induction system 100 may block the flow path connecting the discharging tube 3000 and the exhaust system to each other or stop the operation of the exhaust pump so that the synthesis gas generated in the discharging tube 3000 may be transferred to the post-processor 300. Alternatively, the plasma induction system 100 may block the flow path connecting the discharging tube 3000 and the exhaust system to each other or stop the operation of the exhaust pump when a certain time may be elapsed after the injection of auxiliary gas is stopped. This may be understood for exhausting synthesis gas containing auxiliary gas and for providing to the post-processor 300 synthesis gas not containing auxiliary gas or having a ratio of the auxiliary gas below a certain level as described above.

The use of auxiliary gas may be minimized (used only in the plasma ignition stage) by the plasma reforming method described above, thereby maximizing the production of synthesis gas where the auxiliary gas is not mixed.

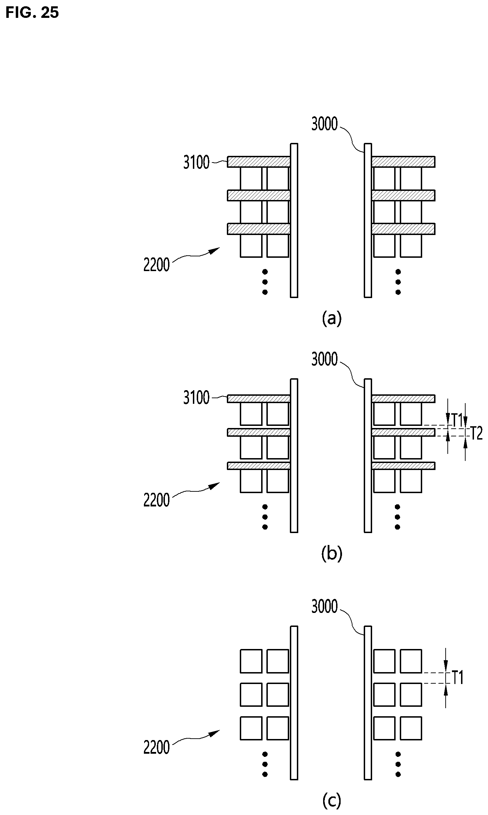

In the following, the design method of the plasma induction system 100 for improving the performance of plasma reforming will be described with reference to FIG. 25.

First, in order to increase the production of synthesis gas or the energy conversion efficiency in the plasma induction system 100, it is necessary to improve the performance of the antenna structure 2000, especially the main antenna structure 2900.

As a way to improve the performance of the main antenna structure 2900, there is a method to reduce the size of parasitic capacitance between layer antennas in designing the main antenna structure 2900. This is to reduce the electric power consumed by the parasitic capacitance between layer antennas so that all of the electric power applied to the main antenna structure 2900 may be supplied to plasma without unnecessary power consumption.

In other words, even when the same voltage (or electric power) is applied to the main antenna structure 2900, as the parasitic capacitance within the main antenna structure 2900 becomes smaller, the electric power consumed by the main antenna structure 2900 may decrease, and the electric power supplied to plasma may increase, thereby increasing the production amount of synthesis gas.

Meanwhile, when a relatively high voltage is applied to the main antenna structure 2900, arcing may occur between layer antennas in the main antenna structure 2900, and in order to prevent such arcing from occurring, it is inevitable to insert a dielectric such as quartz between the layer antennas, and a dielectric insertion may lead to an increase in parasitic capacitance, thereby becoming a factor in deteriorating the performance of the plasma induction system 100.

Conducted has been an experiment where parasitic capacitance is reduced but arcing may not occur using a main antenna structure 2900 having a shape of 2-division, and as a result, it is confirmed that the production amount of synthesis gas and the energy conversion efficiency are improved when placing a certain size of air gap between layer antennas in the main antenna structure 2900.

The experimental data is shown below.

**Table 2**

| **No.** | **Setup** | **Inlet Composition** | | | | **Outlet Composition** | **ECE (%)** |
|---|---|---|---|---|---|---|---|
| | | **CH₄ (LPM)** | **CO₂ (LPM)** | **Ar (LPM)** | **H₂O (cc)** | **Syngas (LPM)** | |
| 1 | quartz disk | 41 | 24 | 0 | 70 | 132.41 | 62.56 |
| 2 | lower nozzle direction CCW | 41 | 24 | 0 | 70 | 134.64 | 62.35 |
| 3 | quartz disk + air gap 1 mm lower nozzle direction CCW | 41 | 24 | 0 | 70 | 151.03 | 63.95 |
| 4 | air gap 3 mm | 41 | 24 | 0 | 70 | 140.86 | 64.53 |
| 5 | lower nozzle direction CCW | 41 | 24 | 0 | 70 | 140.63 | 66 |
| 6 | quartz disk + air gap 1 mm | 41 | 24 | 0 | 70 | 148.95 | 67.19 |
| 7 | lower nozzle direction CW | 41 | 24 | 0 | 70 | 155.44 | 66.92 |
| 8 | air gap 3 mm | 41 | 24 | 0 | 70 | 153.09 | 68.68 |
| 9 | lower nozzle direction CW | 41 | 24 | 0 | 70 | 163.97 | 69.05 |

The adjusted dielectric form of the main antenna structure 2900 performed in the experiment is as shown in FIG. 25. FIG. 25 is views showing a main antenna structure 2900 of which parasitic capacitance is differently adjusted according to an exemplary embodiment. Referring to FIG. 25(a), a dielectric 3100 may be disposed between layer antennas in the main antenna structure 2900 without an air gap, and the Setup of Experiment 1 and Experiment 2 in Table 2 corresponds to this. Referring to FIG. 25(b), a dielectric 3100 having a first thickness T1 of an air gap and a second thickness T2 of an air gap may be disposed between layer antennas in the main antenna structure 2900, and the Setup of Experiment 3 in Table 2 corresponds to this (the first thickness T1 is 1 mm and the second thickness T2 is 2 mm in Experiment 3). Referring to FIG. 25(c), the layer antennas in the main antenna structure 2900 are spaced apart as much as the first thickness T1, and the dielectric 3100 is not inserted, and the Setup of Experiment 4 and Experiment 5 in Table 2 corresponds to this (the first thickness T1 in Experiment 4 and Experiment 5 is 3 mm).

When comparing Experiments 1&2 and Experiment 3 in Table 2, the production amount of synthesis gas is increased and the energy conversion efficiency is higher when the quartz disk is disposed and spaced apart as many as 1 mm than only when the quartz disk may be disposed between the main antenna structures 2900.

When comparing Experiments 1&2 and Experiments 4&5 in Table 2, the amount production of synthesis gas is increased and the energy conversion efficiency is higher when the main antenna structures are spaced apart as many as 3 mm without disposing the quartz disks than when only the quartz disks are disposed between the main antenna structures 2900.

When comparing Experiment 3 and Experiments 4&5 in Table 2, the amount production of synthesis gas is increased but the energy conversion efficiency is lower when quartz disks are disposed and spaced apart as many as 1 mm between the main antenna structures 2900 than when the main antenna structures are spaced apart as many as 3 mm without disposing the quartz disks.

When comparing Experiment 6&7 and Experiment 8&9 in Table 2 the amount production of synthesis gas is increased and the energy conversion efficiency is higher when the main antenna structures are spaced apart as many as 3 mm without disposing the quartz disks than when quartz disks are disposed and spaced apart as many as 1 mm between the main antenna structures 2900.

Considering the experimental results above, it may be preferable to have layer antennas in the main antenna structure 2900 be spaced apart as much as a certain size of a gap and not to dispose dielectric 3100 in order to improve the performance of the plasma induction system 100.

The size of the gap may be determined on the basis of at least one selected from the diameter of the discharging tube 3000, the length of the discharging tube 3000, the length of the ignition antenna structure 2800 in a direction parallel to the central axis of the discharging tube 3000, and the length of the main antenna structure 2900 in a direction parallel to the central axis of the discharging tube 3000. For example, when the diameter of the discharging tube 3000 is about 80 mm and the length of the discharging tube 3000 is about 250 mm, the size of the gap may be about 3 mm.

In the following, a method of determining the swirl direction of the gas injected into the discharging tube 3000 in order to improve the performance of plasma reforming will be described.

In the plasma induction system 100, the flowing gas injected into the discharging tube 3000 basically has a swirl, and the swirl direction may be divided into a clockwise (CW) direction or a counter-clockwise (CCW) direction when viewed from the top of the discharging tube 3000 toward the inside of the discharging tube 3000.

The gas flows into the discharging tube 3000 through the swirl generator, and the swirl direction of the gas in the discharging tube 3000 may be determined depending on the structure of the swirl generator.

Meanwhile, in the gas reforming system 10 described in the present disclosure, the feed gas may be divided into the first sub-feed stream and the second sub-feed stream in the preprocessor 200, and the first sub-feed stream, the second sub-feed stream, and the water vapor may be injected into the discharging tube 3000 of the plasma induction system 100 through different flow paths respectively.

Referring to FIG. 23, the first sub-feed stream may form a clockwise or counter-clockwise swirl by the upper swirl generator 7100 and may flow into the discharging tube 3000. The second sub-feed stream may form a clockwise or counter-clockwise direction of swirl by the first lower swirl generator 7200 and may flow into the discharging tube 3000. The water vapor may form a clockwise or counter-clockwise direction of swirl by the second lower swirl generator 7300 and may flow into the discharging tube 3000.

At this time, not only the design of the antenna structure 2000 but also the swirl direction of the gas injected into the discharging tube 3000 may be an important factor in improving the performance of the plasma induction system 100. In particular, in the case of the second sub-feed stream and water vapor flowing into the rear end of the plasma induction region (PIR), the degree of chemical reaction varies depending on whether the swirl direction of each gas is the same or opposite, thereby affecting the production amount of synthesis gas and the energy conversion efficiency.

The effect of the swirl direction of gas in the discharging tube 3000 on the production amount of synthesis gas and the energy conversion efficiency has been studied, and through experiments, it has been confirmed that the production amount of synthesis gas and the energy conversion efficiency may increase when the swirl direction of the second sub-feed stream and the swirl direction of water vapor are opposite to each other.

The experimental data is shown below.

**Table 3**

| **No.** | **Setup** | **Inlet Composition** | | | | **Outlet Composition** | **ECE (%)** |
|---|---|---|---|---|---|---|---|
| | | **CH₄ (LPM)** | **CO₂ (LPM)** | **Ar (LPM)** | **H₂O (cc)** | **Syngas (LPM)** | |
| 1 | quartz disk + air gap 1 mm | 41 | 24 | 0 | 70 | 151.03 | 63.95 |
| | lower nozzle direction CCW | | | | | | |
| 2 | quartz disk + air gap 1 mm | 41 | 24 | 0 | 70 | 148.95 | 67.19 |
| 3 | lower nozzle direction CW | 41 | 24 | 0 | 70 | 155.44 | 66.92 |
| 4 | air gap 3 mm | 41 | 24 | 0 | 70 | 140.86 | 64.53 |
| 5 | lower nozzle direction CCW | 41 | 24 | 0 | 70 | 140.63 | 66 |
| 6 | air gap 3 mm | 41 | 24 | 0 | 70 | 153.09 | 68.68 |
| 7 | lower nozzle direction CW | 41 | 24 | 0 | 70 | 163.97 | 69.05 |

In the experiment above, the lower nozzle direction may mean the swirl direction of the second sub-feed stream, and in all experiments, the swirl direction of the water vapor is counter-clockwise direction (CCW), and the swirl direction of the first sub-feed stream is clockwise (CW) direction. When comparing Experiment 1 and Experiment 2&3 in Table 3, the production amount of synthesis gas is increased and the energy conversion efficiency is higher when the swirl direction of the second sub-feed stream and the swirl direction of water vapor are designed to be in the opposite direction to each other than to be in the same counter-clockwise direction.

Likewise, when comparing Experiment 4&5 and Experiment 6&7 in Table 3, the production amount of synthesis gas is increased and the energy conversion efficiency is higher when the swirl direction of the second sub-feed stream and the swirl direction of water vapor are designed to be in the opposite direction to each other than to be in the same counter-clockwise direction.

Considering the experimental results above, the first lower swirl generator 7200 and the second lower swirl generator 7300 need to be designed such that the swirl direction of the second sub-feed stream and the swirl direction of water vapor are in an opposite direction to each other in order to improve the performance of the plasma induction system 100.

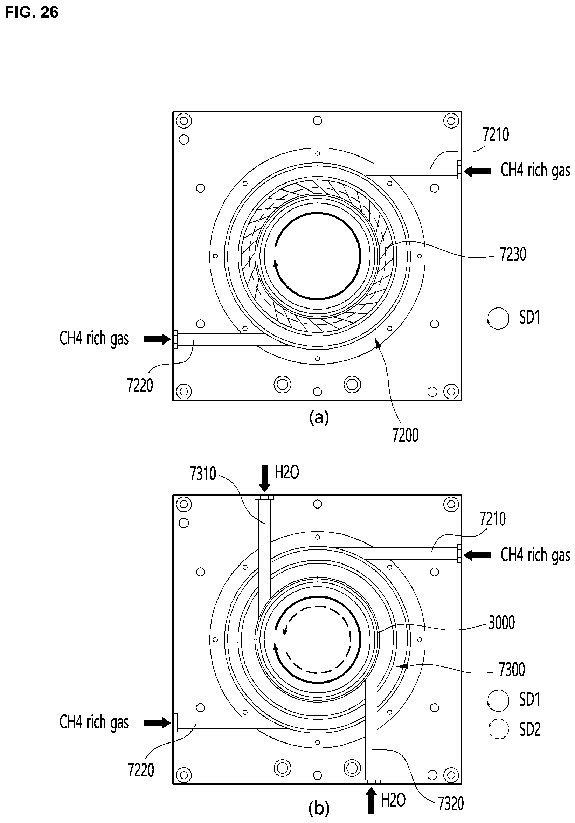

Hereinafter, the structures of the first lower swirl generator 7200 and the second lower swirl generator 7300 will be described with reference to FIG. 26.

FIG. 26 are views showing the lower swirl generator 7200 and 7300 according to exemplary embodiments. FIG. 26(a) shows a first lower swirl generator 7200, and FIG. 26(b) shows a second lower swirl generator 7300 positioned at the upper end of the first lower swirl generator 7200.

The first lower swirl generator 7200 may be supplied with the second sub-feed stream and transfer the second sub-feed stream into the discharging tube 3000. The first lower swirl generator 7200 may include a first inlet tube 7210, a second inlet tube 7220, and a nozzle part 7230.

The first inlet tube 7210 and the second inlet tube 7220 may be tubes connected to a gas supplier in order to be supplied with gas. For example, the first inlet tube 7210 and the second inlet tube 7220 may be connected to the second gas separation tube 232 to which the second sub-feed stream is supplied.

The nozzle part 7230 may transfer the gas flowing into the first inlet tube 7210 or the second inlet tube 7220 into the discharging tube 3000 and may form a swirl in the process. For example, the nozzle part 7230 may include a plurality of nozzle tubes arranged in a spiral shape on the basis of the center of the first lower swirl generator 7200.

Depending on the direction in which the nozzle tubes of the nozzle part 7230 are disposed, the gas passing through the nozzle part 7230 may have a clockwise or counter-clockwise swirl shape. Referring to FIG. 26, the gas supplied to the discharging tube 3000 through the first lower swirl generator 7200 may have a clockwise swirl shape.

The second lower swirl generator 7300 may be supplied with water vapor and transfer it into the inside of the discharging tube 3000.

The second lower swirl generator 7300 may include a third inlet tube 7310 and a fourth inlet tube 7320.

The third inlet tube 7310 and the fourth inlet tube 7320 may be tubes connected to another gas supplier in order to be supplied with gas. For example, the third inlet tube 7310 and the fourth inlet tube 7320 may be connected to the steam supply module 6200 and be supplied with water vapor.

The third inlet tube 7310 and the fourth inlet tube 7320 may be disposed such that the supplied gas has a swirl in a specific direction. For example, as shown in FIG. 26, the third inlet tube 7310 and the fourth inlet tube 7320 may be disposed in a way of contacting with the discharging tube 3000, and the gas flowing from the third inlet tube 7310 and the fourth inlet tube 7320 may rotate along the edge or the inner side surface of the discharging tube 3000. In this case, the swirl direction of the gas passing through the second lower swirl generator 7300 may be set to a clockwise or counter-clockwise direction depending on the arrangement direction of the third inlet tube 7310 and the fourth inlet tube 7320.

It may be designed that each of the gases passing through the first lower swirl generator 7200 and the second lower swirl generator 7300 may have swirls in opposite directions. For example, referring to FIG. 26(b), the swirl direction of the methane-rich gas passing through the first lower swirl generator 7200 may be in a clockwise direction, and the swirl direction of the water vapor passing through the second lower swirl generator 7300 may be in a counter-clockwise direction.

The gas passing through each of the first lower swirl generator 7200 and the second lower swirl generator 7300 may move between the discharging tube 3000 and the guide structure 8000 and then reach the rear end of the plasma induction region (PIR) as shown in FIG. 23.

In this way, different gases flowing into the rear end of the plasma induction region (PIR) in the discharging tube 3000 through the lower swirl generators 7200 and 7300 may have different swirl directions such that chemical reactions may be more active and the gas reforming efficiency may be improved.

The features, structures, effects, etc. described in the above embodiments are included in at least one embodiment of the present disclosure, but are not necessarily limited to only one embodiment. Further, the features, structures, effects, etc. exemplified in each embodiment may be combined or modified also in other embodiments by those skilled in the art to which the embodiment are pertained. Accordingly, configurations related to the combinations and modifications should be construed as being included in the range of the present disclosure.

Although the present disclosure was described above with reference to embodiments, the embodiments are only examples and do not limit the present disclosure, and those skilled in the art would know that the present disclosure may be changed and modified in various ways not exemplified above without departing from the scope of the present disclosure. That is, the components described in detail in the embodiments of the present disclosure may be modified. Further, differences relating to the changes and modifications should be construed as being included in the scope of the present disclosure which is determined by claims.

## Claims

1. An antenna structure disposed around a side perimeter of a discharging tube providing a space in which a plasma is generated, the antenna structure comprising:
n unit antennas including a first unit antenna to n-th unit antenna, where n is natural number greater than or equal to 2,
wherein each of n unit antennas comprises:
a first arc section, having a first radius of curvature, including a first end and a second end;
a second arc section, having a second radius of curvature, including a third end and a fourth end; and
an arc connecting section, the second end of the first arc section and the third end of the second arc section,
wherein m-th unit antenna and (m+1)-th unit antenna are disposed so that an angle formed by a first virtual line and a second virtual line is 360/n degree,
wherein the first virtual line is drawn between a center of the discharging tube and an arc connecting section of the m-th unit antenna,
wherein the second virtual line is drawn between the center of the discharging tube and an arc connecting section of the (m+1)-th unit antenna,
wherein the m-th unit antenna and the (m+1)-th unit antenna are adjacent and m is natural number smaller than n, and
wherein the first radius of curvature is different from the second radius of curvature.

2. The antenna structure of Claim 1, wherein the first radius of curvature corresponds to the side perimeter of the discharging tube, and
wherein the second radius of curvature has larger value than the first radius of curvature.

3. The antenna structure of Claim 1, wherein the first arc section has a first central angle, and the first central angle is equal to or less than 360/n degree.

4. The antenna structure of Claim 3, wherein the second arc section has a second central angle, and the second central angle is smaller than the first central angle.

5. The antenna structure of Claim 1, wherein n is natural number greater than or equal to 3, and m is natural number less then (n-1), and
wherein a fourth end of a second arc section of the m-th unit antenna and a first end of a first arc section of the (m+2)-th unit antenna are electrically connected when the (m+2)-th unit antenna and the (m+1)-th unit antenna are adjacent.

6. The antenna structure of Claim 5, wherein an inter-turn capacitor is electrically interposed between the fourth end of the second arc section of the m-th unit antenna and the first end of the first arc section of the (m+2)-th unit antenna.

7. The antenna structure of Claim 1, wherein the n unit antennas are disposed at a first plane to form a first layer antenna.

8. The antenna structure of Claim 7, wherein the first radius of curvature is smaller than the second radius of curvature,
wherein first arc sections of the first to n-th unit antennas consist of an inner turn of the first layer antenna to surround the discharging tube, and
wherein second arc sections of the first to n-th unit antennas consist of an outer turn of the first layer antenna to surround the inner turn.

9. The antenna structure of Claim 7, wherein the n antennas are disposed clockwise or counterclockwise at the first plane, and
wherein a second arc section of the m-th unit antenna is disposed to surround at least part of a first arc section of the (m+1)-th unit antenna.

10. The antenna structure of Claim 7, the antenna structure further comprising:
a second layer antenna consisting of p unit antennas different from the n unit antennas,
wherein p is natural number greater than or equal to 2,
wherein the second layer antenna is disposed at a second plane spaced a predetermined distance from the first plane,
wherein one of the n unit antennas and one of the p unit antennas are electrically connected through inter-layer capacitor.

11. The antenna structure of Claim 1, where n is 3,
wherein a fourth end of a second arc section of the first unit antenna is connected to a first end of a first arc section of the third unit antenna through a first inter-turn capacitor, and
wherein a fourth end of a second arc section of the third unit antenna is connected to a first end of a first arc section of the second unit antenna through a second inter-turn capacitor.
